# EUROPÄISCHE PATENTANMELDUNG

(11) **EP 3 770 622 A2**
(43) Veröffentlichungstag der Anmeldung: **27.01.2021**
(21) Anmeldenummer: 20160333.9
(22) Anmeldetag: 02.03.2020
(51) Int. Cl.: G01R 33/24, G01R 33/26, G01R 33/28, G01R 33/36, G01R 33/44, G01R 33/46, G01R 33/565

(54) **RASER- UND/ODER NMR-SPEKTROSKOPIE-VORRICHTUNG, VERWENDUNG EINER SOLCHEN VORRICHTUNG, SYSTEM MIT ZWEI SOLCHEN VORRICHTUNGEN UND VERFAHREN ZUM BETRIEB EINER SOLCHEN VORRICHTUNG SOWIE EINES SOLCHEN SYSTEMS**

(30) Priorität: 18.04.2019 DE 102019110358
(71) Anmelder: Forschungszentrum Jülich GmbH, 52425 Jülich (DE)
(72) Erfinder: Degenhardt, Carsten, 52078 Aachen (DE); Appelt, Stephan, 52070 Aachen-Soers (DE); van Waasen, Stefan, 41836 Hückelhoven (DE); Czylwik, Andreas, 68642 Bürstadt-Bobstadt (DE)
(74) Vertreter: Paul & Albrecht Patentanwälte PartG mbB

(57) **Zusammenfassung**

Die Erfindung betrifft eine RASER- und/oder NMR-Spektroskopie-Vorrichtung 2, 3 umfassend eine elektrische Schaltung 4a,b, die einen elektrischen Schwingkreis 5a,b mit einer insbesondere zylinderförmigen oder flachen Schwingkreisspule 6a,b, die einen Aufnahmeraum 7a,b, in dem ein aktives Medium 8a,b angeordnet oder anordenbar ist, um mit der Schwingkreisspule 6a,b insbesondere über Faradayinduktion wechselzuwirken, umgibt, und einem insbesondere einstellbaren Kondensator 9a,b aufweist, wobei die elektrische Schaltung 4a,b, insbesondere der elektrische Schwingkreis 5a,b eine aktive elektronische Einrichtung 11a,b aufweist, die zur aktiven Entdämpfung des elektrischen Schwingkreises 5a,b ausgebildet ist. Darüber hinaus betrifft die Erfindung eine Verwendung einer derartigen Vorrichtung 2, 3. Des Weiteren betrifft die vorliegende Erfindung ein System 1 mit zwei derartigen Vorrichtungen 2, 3. Außerdem betrifft die Erfindung Verfahren zum Betrieb einer derartigen Vorrichtung 2, 3 sowie eines derartigen Systems 1.

## Beschreibung

Die vorliegende Erfindung betrifft eine RASER- und/oder NMR-Spektroskopie-Vorrichtung umfassend eine elektrische Schaltung, die einen elektrischen Schwingkreis mit einer insbesondere zylinderförmigen oder flachen Schwingkreisspule, die einen Aufnahmeraum, in dem ein aktives Medium angeordnet oder anordenbar ist, um mit der Schwingkreisspule insbesondere über Faradayinduktion wechselzuwirken, umgibt, und einem insbesondere einstellbaren Kondensator aufweist. Darüber hinaus betrifft die Erfindung eine Verwendung einer derartigen Vorrichtung. Des Weiteren betrifft die Erfindung ein System mit zwei derartigen Vorrichtungen. Außerdem betrifft die Erfindung Verfahren zum Betrieb einer derartigen Vorrichtung sowie eines derartigen Systems.

Vorrichtungen zur Durchführung von NMR-Untersuchungen an einem aktiven Medium, kurz NMR-Vorrichtungen, insbesondere NMR-Spektroskopie-Vorrichtungen, sowie die Wirkmechanismen der NMR sind seit langem bekannt. Hierbei steht die Abkürzung "NMR" für "Nuclear Magnetic Resonance", also Nukleare Magnetresonanz oder Kernspinresonanz. Bei NMR-Untersuchungen geht es insbesondere darum, chemische Substanzen zu untersuchen und/oder nachzuweisen. Hierzu können gemessene NMR-Signale und/oder die Frequenz von gemessenen Kernspinresonanzen ausgewertet werden. Eine Standard-NMR-Vorrichtung umfasst beispielsweise einen Magneten, der dazu dient, ein homogenes, statisches Magnetfeld zu erzeugen, eine Empfängerspule, die einen Aufnahmeraum, in dem ein zu untersuchendes aktives Medium angeordnet oder anordenbar ist, um mit der Empfängerspule über Faradayinduktion wechselzuwirken, umgibt, und eine Hochfrequenzanregungsspule. Während des Betriebs einer solchen Standard-NMR-Vorrichtung ist die Empfängerspule mit einem in ihrem Aufnahmeraum angeordneten aktiven Medium innerhalb des homogenen, statischen Magnetfelds angeordnet. Das aktive Medium wird dem homogenen, statischen Magnetfeld ausgesetzt, wodurch zumindest ein Teil der Kernspins von Atomen und/oder Molekülen des aktiven Mediums in Richtung des homogenen, statischen Magnetfelds ausgerichtet wird. Der Grad der Ausrichtung der Kernspins, die sogenannte Polarisation P, ist in der Regel sehr klein, beispielsweise P ∼ 3 · 10⁻⁶ bei 1 T und 300 K für Protonen. Insbesondere ist P > 0, also positiv, d.h. der untere Zustand ist mehr besetzt als der obere. Dieser Besetzungszustand wird durch eine positive Spintemperatur beschrieben. Mittels der Hochfrequenzanregungsspule wird ein Hochfrequenz-Anregungsimpuls in Form eines zeitlich begrenzten hochfrequenten magnetischen Wechselfeldes erzeugt und das aktive Medium dem Hochfrequenz-Anregungsimpuls ausgesetzt, sodass das aktive Medium von diesem angeregt wird. Die Kernspins des angeregten aktiven Mediums induzieren durch magnetische Induktion eine Spannung in der Empfängerspule, die entsprechend messbar und auswertbar ist. Bei einer weiteren Standard-NMR-Vorrichtung ist die Anregungs- und Empfangsspule identisch, was in der Regel eine T-Brücke zur sauberen Trennung von Senden und Empfangen erforderlich macht.

NMR-Signale sind in ihrer Auflösung durch die transversale Relaxationsrate T2 intrinsisch begrenzt. Daher versucht man bei Standard-NMR-Vorrichtungen einer begrenzten Frequenzauflösung durch den Einsatz immer höherer und homogener Magnetfelder entgegenzuwirken. Die dazu notwendigen supraleitenden Hochfeldmagnete stoßen jedoch an die Grenzen des technisch und finanziell Machbaren.

Vor diesem Hintergrund gab es Bemühungen, eine Alternative zu den bisher bekannten Standard-NMR-Vorrichtungen zu finden. Seit langem bekannt ist die stimulierte Emission in quantenmechanischen Systemen als Möglichkeit zur Verstärkung elektromagnetischer Strahlung, die bereits im Jahre 1916 von Albert Einstein postuliert wurde. In den 1950er Jahren wurde der MASER (Microwave Amplification by Stimulated Emission of Radiation) erfunden, der elektromagnetische Strahlung und/oder Oszillationen im Mikrowellen-Frequenzbereich erzeugt und/oder verstärkt. Kurz darauf im Jahr 1960 wurde der allgemein bekannte LASER (Light Amplification by Stimulated Emission of Radiation) erfunden, der elektromagnetische Strahlung und/oder Oszillationen im optischen Frequenzbereich erzeugt und/oder verstärkt. MASER und LASER kommen heute bereits in unterschiedlichen Gebieten zum Einsatz. Erst seit kurzem sind RASER (Radiowave Amplification by Stimulated Emission of Radiation) bekannt, die auch als Radiowellen-MASER bezeichnet werden und elektromagnetische Strahlung und/oder Oszillationen im Radiowellen-Frequenzbereich, also im Megahertz- bis Kilohertz-Frequenzbereich, erzeugen und/oder verstärken. Bei der in der vorliegenden Anmeldung verwendeten Bezeichnung "RASER-Vorrichtung" kann es sich entsprechend um eine Vorrichtung zur Verstärkung elektromagnetischer Strahlung, die von einem aktiven Medium insbesondere in einem Zustand negativer Kernspinpolarisation (entspricht Besetzungsinversion) emittiert wird, handeln. Die Oszillationen bei einem LASER, MASER und RASER werden durch stimulierte Emissionen eines angeregten und/oder gepumpten aktiven Mediums erzeugt, wobei der mit stimulierten Emissionen verbundene Verstärkungseffekt genutzt wird, um elektromagnetische Schwingungen in einem Schwingkreis beziehungsweise Resonator anzuregen. Ein stationärer Zustand der elektromagnetischen Strahlung ist erreicht, wenn der verstärkende Effekt durch stimulierte Emission von den Verlusten des aktiven Mediums und des Schwingkreises beziehungsweise Resonators kompensiert wird.LASER, MASER und RASER unterscheiden sich also in dem Bereich des elektromagnetischen Spektrums, in dem sie arbeiten. Im Folgenden wird daher der Einfachheit halber lediglich der Begriff "RASER" verwendet, der RASER und/oder MASER umfasst.

Unter Kenntnis der soeben beschriebenen Effekte stimulierter Emission in quantenmechanischen Systemen ergab sich ein Ansatz, wie der intrinsischen Begrenzung der spektralen Auflösung des NMR-Signals ohne Notwendigkeit immer höherer Magnetfelder entgegengewirkt werden kann. So wird von M. Suefke, S. Lehmkuhl, A. Liebisch, B. Blümich und S. Appelt in dem Aufsatz "Para-hydrogen raser delivers sub-millihertz resolution in nuclear magnetic resonance", Nature Physics 6, 568-572 (2017) eine Alternative zu den bisher bekannten Standard-NMR-Vorrichtungen beschrieben. Hierbei wird die intrinsische Begrenzung der spektralen Auflösung des NMR-Signals durch den Einsatz des RASER-Effektes aufgehoben. Aus dem vorgenannten Aufsatz ist eine Vorrichtung zur Verstärkung elektromagnetischer Strahlung, die von einem aktiven Medium präpariert in einem Zustand mit negativer Kernspinpolarisation (p<0, Besetzungsinversion) emittiert wird, und zur Durchführung von NMR-Untersuchungen an dem aktiven Medium, kurz NMR-RASER-Vorrichtung, bekannt. Die NMR-RASER-Vorrichtung umfasst eine elektrische Schaltung, die einen elektrischen Schwingkreis mit einer Schwingkreisspule, die einen Aufnahmeraum, in dem das aktive Medium angeordnet oder anordenbar ist, um mit der Schwingkreisspule über Faradayinduktion wechselzuwirken, umgibt, und mit einem Kondensator aufweist. Darüber hinaus umfasst die NMR-RASER-Vorrichtung einen Magneten, der dazu ausgebildet ist, ein homogenes, statisches Magnetfeld zu erzeugen, und eine Pump-Einrichtung. Während des Betriebs der NMR-RASER-Vorrichtung ist die Schwingkreisspule mit einem in ihrem Aufnahmeraum angeordneten aktiven Medium innerhalb des homogenen, statischen Magnetfelds angeordnet. Das aktive Medium wird entsprechend dem homogenen, statischen Magnetfeld ausgesetzt, wodurch zumindest ein Teil der Kernspins von Atomen und/oder Molekülen des aktiven Mediums zunächst in sehr geringem Maße (P ∼ 10⁻⁸ bei 0,01 T) in Richtung des homogenen, statischen Magnetfelds ausgerichtet werden. Dann wird das aktive Medium mittels der Pump-Einrichtung gepumpt, wodurch eine Besetzungsinversion oder negative Kernspinpolarisation in der Größenordnung P ∼ - 10⁻³ bis - 10⁻¹ von Energiezuständen der Atome und/oder Moleküle des aktiven Mediums hergestellt wird. Das aktive Medium wird durch das Pumpen zur RASER-Tätigkeit angeregt, d.h., es emittiert durch spontane Emission elektromagnetische Strahlung, die in der Schwingkreisspule eine Spannung induziert. Erst wenn der getätigte Pumpaufwand groß genug ist, d.h. die sogenannte RASER-Schwelle erreicht und/oder überschritten wird, beginnt der elektrische Schwingkreis zu schwingen. Die RASER-Schwelle ist also die Schwelle, d.h. die minimal notwendige negative Kernspinpolarisation Ps, ab der der elektrische Schwingkreis mit samt Probe beziehungsweise aktivem Medium zu schwingen beginnt. Hierbei gilt der Zusammenhang Ps ∼ (-1)/(N•Q•T₂*), wobei N für die Zahl der Kernspins im RASER-aktiven Volumen, Q für die Güte des Resonators beziehungsweise des Schwingkreises, T₂* für die effektive transversale Relaxationszeit und "S" für "Schwelle" steht. Anstatt des Begriffs "Güte" kann auch die Bezeichnung "Gütefaktor" verwendet werden. Der negative Vorfaktor (-1) deutet eine negative Polarisation beziehungsweise Besetzungsinversion an. Die NMR-RASER-Vorrichtung im schwingenden Zustand ermöglicht dann eine hochaufgelöste Detektion von NMR-Signalen beziehungsweise eine ultrapräzise NMR-Spektroskopie, mit der sich der Aufbau von Atomen und/oder Molekülen des aktiven Mediums mit hoher Präzision messen lässt.

Nichtsdestotrotz sind insbesondere aufgrund einer begrenzten Güte des Schwingkreises der vorbekannten Standard-NMR-Vorrichtungen und der vorbekannten NMR-RASER-Vorrichtung und des sich daraus ergebenden relativ niedrigen Signal-Rausch-Verhältnisses die Einsatzmöglichkeiten dieser Vorrichtungen begrenzt. Beispielsweise liegt die Güte für Standard-NMR im MHz-Bereich bei Q ∼ 30. Dieser Wert wurde von M. Suefke et al. in dem Aufsatz "External High Quality Enhanced NMR", Nature Physics 11, 767 (2015) durch einen externen Resonator durch Einsatz eines verlustfreien Ferritkerns auf Q ∼ 300 gesteigert. Insbesondere ist die zu überwindende RASER-Schwelle ein begrenzender Faktor für die in Betracht kommenden Einsatzmöglichkeiten der vorbekannten NMR-RASER-Vorrichtung. Somit gibt es Bestrebungen, die vorbekannten Standard-NMR-Vorrichtungen beziehungsweise die vorbekannte NMR-RASER-Vorrichtung weiter zu verbessern.

Vor diesem Hintergrund liegt der vorliegenden Erfindung die Aufgabe zugrunde, die Vorrichtung der eingangs genannten Art derart weiterzuentwickeln, dass diese für weitere Einsatzmöglichkeiten geeignet ist.

Diese Aufgabe ist erfindungsgemäß bei einer Vorrichtung der eingangs genannten Art dadurch gelöst, dass die elektrische Schaltung, insbesondere der elektrische Schwingkreis eine aktive elektronische Einrichtung aufweist, die zur aktiven Entdämpfung des elektrischen Schwingkreises ausgebildet ist.

Der Erfindung liegt somit die Überlegung zugrunde, durch das Vorsehen einer aktiven elektronischen Einrichtung den Schwingkreis aktiv zu entdämpfen, also die ohmschen Verluste im Schwingkreis zu reduzieren, indem durch die aktive elektronische Einrichtung ein negativer elektrischer Widerstand in die elektrische Schaltung beziehungsweise in den Schwingkreis eingebracht wird, und somit die Güte des Schwingkreises zu erhöhen, wodurch sich insbesondere ein verbessertes, also größeres Signal-Rausch-Verhältnis der Vorrichtung ergibt. Auf diese Weise lässt sich verglichen mit den vorbekannten Vorrichtungen am Schwingkreis ein Ausgangssignal mit einem höheren Signal-Rausch-Verhältnis SNR ∼ Sqrt(Q) erzeugen und abgreifen. Grundsätzlich lassen sich mit der erfindungsgemäßen Vorrichtung bei geeigneter Wahl und bei geeignetem Betrieb der aktiven elektronischen Einrichtung beliebig hohe Güten des Schwingkreises erreichen. Somit ist die erfindungsgemäße Vorrichtung verglichen mit den vorbekannten Vorrichtungen vielfältiger einsetzbar. Wo die Grenze für SNR ∼ Sqrt(Q) liegt, ist bisher eine offene Frage. Sicher ist, dass die Heisenbergsche Unschärferelation eine fundamentale Grenze für das SNR setzt. Die technische Grenze für NMR-Detektion ist dort, wo die aktive Entdämpfung so stark ist, dass der Schwingkreis beziehungsweise Resonanzkreis ohne Anwesenheit einer Probe mit negativer Spintemperatur anfängt zu schwingen. Bei der erfindungsgemäßen Vorrichtung kann es sich um eine Haupt-Vorrichtung zur Erfassung eines Haupt-Messsignals oder um eine Referenz-Vorrichtung zur Erfassung eines Referenz-Messsignals handeln.

Gemäß einer Ausgestaltung der Erfindung ist die aktive elektronische Einrichtung dazu ausgebildet und/oder eingerichtet, negative Impedanz zu erzeugen.

Zweckmäßigerweise ist die aktive elektronische Einrichtung dazu ausgebildet und/oder eingerichtet, mit externer elektrischer Energie versorgt zu werden, wobei die aktive elektronische Einrichtung, insbesondere wenigstens eine Komponente von dieser bevorzugt wenigstens zwei Anschlüsse zur Verbindung mit einer Spannungs- und/oder Stromquelle aufweist. Auf diese Weise kann zumindest ein Teil der externen elektrischen Energie, mit der die aktive elektronische Einrichtung versorgt wird, mittels der aktiven elektronischen Einrichtung dem elektrischen Schwingkreis zugeführt werden, um die ohmschen Verluste im Schwingkreis zumindest teilweise zu kompensieren.

Die aktive elektronische Einrichtung kann einen Transistor, einen Verstärker, eine Diode, eine NIC-Schaltung und/oder eine Schaltung mit einer oder mehreren dieser Komponenten umfassen oder daraus bestehen. Bei dem Transistor kann es sich beispielsweise um einen Feldeffekttransistor, FET, handeln. Der Verstärker kann beispielsweise ein Operationsverstärker sein. Bei der Diode kann es sich beispielsweise um eine Tunneldiode, insbesondere eine Tunneldiode mit negativer Impedanz und/oder eine Esaki-Tunneldiode, und/oder eine Diode mit einer Spannungs-Strom (U-I) Kennlinie, wo mindestens ein Bereich eine negative Steigung aufweist, handeln. Die NIC-Schaltung kann beispielsweise eine INIC- oder UNIC-Schaltung sein. Die Abkürzung "NIC" steht gemäß dem Buch "Halbleiter-Schaltungstechnik", Springer Verlag, 15. überarbeitete und erweiterte Auflage, von Ulrich Tietze, Christoph Schenk und Eberhard Gamm (siehe z.B. Seite 781) für "Negative Impedance Converter", also negativer Impedanzkonverter. Die Abkürzung "UNIC" steht für "Negative Impedance Converter with voltage inversion ", d.h. dieser polt die Spannung bei gleichbleibendem Strom um. Die Abkürzung "INIC" steht für "Negative Impedance Converter with current inversion ", d.h. dieser kehrt die Stromrichtung bei gleichbleibender Spannung um. Vorzugsweise erfolgt die Wahl beispielsweise eines Operationsverstärkers, eines Transistors oder einer Tunneldiode in Abhängigkeit von der Schwingungsfrequenz. Eine Tunneldiode ist insbesondere bei zu verstärkenden Schwingungsfrequenzen > 1GHz vorteilhaft, während NIC oder FET bei niedrigeren Frequenzen im MHz-Bereich eingesetzt werden.

Bevorzugt umfasst die aktive elektronische Einrichtung eine Operationsverstärkerschaltung, die einen ersten Widerstand, einen zweiten Widerstand und einen Operationsverstärker, dessen Ausgang bevorzugt unter Zwischenschaltung des ersten Widerstands mit dessen positivem Eingang elektrisch verbunden ist und unter Zwischenschaltung des zweiten Widerstands mit dessen negativem Eingang elektrisch verbunden ist, und der Anschlüsse zum Anlegen einer externen Versorgungsspannung für den Operationsverstärker aufweist, umfasst. Der erste und der zweite Widerstand der Operationsverstärkerschaltung sind zweckmäßigerweise gleich groß. Insbesondere umfasst die aktive elektronische Einrichtung eine NIC-Schaltung oder besteht daraus. Die Operationsverstärkerschaltung kann Teil der NIC-Schaltung der aktiven elektronischen Einrichtung sein.

Der elektrische Schwingkreis kann ein Parallelschwingkreis sein, bei dem die Schwingkreisspule parallel zu dem Kondensator geschaltet ist, und die aktive elektronische Einrichtung kann parallel zu dem Kondensator geschaltet sein. Falls die aktive elektronische Einrichtung einen Operationsverstärker umfasst, kann dessen positiver Eingang mit einer Seite des Kondensators, beispielsweise einer Seitenfläche eines Plattenkondensators, und dessen negativer Eingang insbesondere indirekt über eine oder mehrere weitere Komponenten, vorzugsweise unter Zwischenschaltung eines weiteren in bevorzugter Ausgestaltung regelbaren Widerstands, mit der anderen Seite des Kondensators, insbesondere Plattenkondensators, beispielsweise einer anderen insbesondere gegenüberliegenden Seitenfläche des Plattenkondensators, elektrisch verbunden sein. Der negative Eingang des Operationsverstärkers ist dann mit der anderen Seite des Kondensators über den weiteren Widerstand indirekt verbunden. Alternativ ist der elektrische Schwingkreis ein Reihenschwingkreis.

In bevorzugter Ausgestaltung ist die aktive elektronische Einrichtung derart ausgebildet und/oder eingerichtet, dass die Stärke der von ihr bewirkten Entdämpfung einstellbar, insbesondere regelbar ist, wobei die aktive elektronische Einrichtung vorzugsweise wenigstens einen regelbaren Widerstand, insbesondere ein Potentiometer und/oder einen elektrisch regelbaren Widerstand, insbesondere einen Transistor, bevorzugt einen insbesondere rauscharmen Feldeffekttransistor, umfasst. Die aktive elektronische Einrichtung kann eine NIC-Schaltung umfassen oder daraus bestehen. Der regelbare Widerstand kann Teil der NIC-Schaltung der aktiven elektronischen Einrichtung sein. Der regelbare Widerstand kann mit der zuvor beschriebenen Operationsverstärkerschaltung in Reihe geschaltet sein, insbesondere zwischen dem negativen Eingang des Operationsverstärkers und einer Seite des Kondensators.

Zweckmäßigerweise weist der Kondensator eine erste Kapazität auf und umfasst die elektrische Schaltung eine parallel zu dem Kondensator geschaltete Kapazitätsdiode mit einer zweiten Kapazität, über welche eine sich aus der Summe der ersten und zweiten Kapazitäten ergebende Gesamtkapazität einstellbar ist. Auf diese Weise lässt sich die Frequenz des Resonators oder des Schwingkreises einstellen.

Vorteilhaft umfasst die elektrische Schaltung einen insbesondere parallel zu der aktiven elektronischen Einrichtung geschalteten bevorzugt rauscharmen Verstärker, insbesondere Instrumentenverstärker und/oder Vorverstärker, der dazu ausgebildet und/oder eingerichtet ist, ein insbesondere analoges Ausgangszeitsignal, insbesondere Spannungszeitsignal, des elektrischen Schwingkreises, insbesondere an der aktiven elektronischen Einrichtung, abzugreifen und zu verstärken. Die elektrische Schaltung kann einen Analog-Digital-Wandler umfassen, der dazu ausgebildet und/oder eingerichtet ist, ein von dem Verstärker empfangenes analoges Ausgangszeitsignal in ein digitales Ausgangszeitsignal umzuwandeln und das digitale Ausgangszeitsignal insbesondere an eine Auswertevorrichtung weiterzuleiten. Unter dem Begriff "Ausgangszeitsignal" ist insbesondere ein zeitabhängiges Ausgangssignal S(t) zu verstehen.

Gemäß einer weiteren vorteilhaften Ausführungsform ist eine insbesondere parallel zu der aktiven elektronischen Einrichtung geschaltete Amplitudenmessschaltung vorgesehen, die dazu ausgebildet und/oder eingerichtet ist, ein bevorzugt analoges Ausgangszeitsignal, insbesondere Spannungszeitsignal, des elektrischen Schwingkreises, insbesondere an der aktiven elektronischen Einrichtung, abzugreifen oder ein von dem Verstärker abgegriffenes Ausgangszeitsignal von diesem zu empfangen und die Amplitude des Ausgangszeitsignals, insbesondere als Schwingungsamplitude des elektrischen Schwingkreises kontinuierlich und/oder zu vorgegebenen, bevorzugt gleichmäßig beabstandeten Zeitpunkten zu erfassen. In die Amplitudenmessschaltung kann eine Auswerteeinheit integriert sein oder die Amplitudenmessschaltung kann mit einer Auswerteeinheit verbunden sein. Die Amplitudenmessschaltung kann dazu ausgebildet und/oder eingerichtet sein, zu der von ihr erfassten Amplitude korrespondierende Amplitudenausgangssignale an die Auswerteeinheit zu übermitteln. Die Auswerteeinheit kann dazu ausgebildet und/oder eingerichtet sein, von der Amplitudenmessschaltung erhaltene Amplitudenausgangssignale weiterzuverarbeiten und/oder diese auszuwerten.

Bevorzugt ist ein Regelkreis für die aktive elektronische Einrichtung vorgesehen, der dazu ausgebildet und/oder eingerichtet ist, eine Schwingungsamplitude des elektrischen Schwingkreises zumindest bis auf eine zulässige Abweichung auf einem vorgegebenen Sollwert, insbesondere einer vorgegebenen Sollamplitude. zu halten, also zu stabilisieren, indem die Schwingungsamplitude erfasst, mit einer Sollamplitude verglichen und entsprechend nachgeregelt wird. Hierbei ist unter dem Begriff "Schwingungsamplitude" insbesondere der positive und/oder negative Maximalwert einer beispielsweise sinus- oder kosinusförmigen Schwingung zu verstehen. Falls bereits eine Amplitudenmessschaltung vorgesehen ist, kann zusätzlich ein Amplitudenstabilisierungsregler vorgesehen sein, der dazu ausgebildet und/oder eingerichtet ist, die von der Amplitudenmessschaltung erfasste Amplitude des abgegriffenen Ausgangszeitsignals des elektrischen Schwingkreises basierend auf dem Ergebnis eines Vergleichs der erfassten Amplitude mit der Sollamplitude nachzuregeln, insbesondere, indem ein negativer elektrischer Widerstand oder eine negative Impedanz der aktiven elektronischen Einrichtung und/oder die von der aktiven elektronischen Einrichtung bewirkte Entdämpfung nachgeregelt wird. Der Vergleich der erfassten Amplitude mit der Sollamplitude kann mittels der zuvor beschriebenen Auswerteeinheit erfolgen. Der Regelkreis umfasst bevorzugt die Amplitudenmessschaltung, den Amplitudenstabilisierungsregler und die Auswerteeinheit, die einerseits mit der Amplitudenmessschaltung verbunden oder darin integriert und andererseits mit dem Amplitudenstabilisierungsregler verbunden oder darin integriert ist. Falls die Auswerteeinheit sowohl in die Amplitudenmessschaltung als auch in den Amplitudenstabilisierungsregler integriert ist, sind die Amplitudenmessschaltung, der Amplitudenstabilisierungsregler und die Auswerteeinheit vorzugsweise Bestandteil einer integrierten Schaltung oder bilden diese. Die Auswerteeinheit ist dann dazu ausgebildet und/oder eingerichtet, die Höhe der von der Amplitudenmessschaltung erhaltenen Amplitudenausgangssignale mit der Sollamplitude zu vergleichen, um zu bestimmen, in welchem Maße es notwendig ist, die Amplitude, insbesondere die Schwingungsamplitude nachzuregeln, und ein entsprechendes Regelungsanweisungssignal an den Amplitudenstabilisierungsregler zu übermitteln. Die Auswerteeinheit kann einen Addierer umfassen, der dazu ausgebildet und/oder eingerichtet ist, die Höhe der von der Amplitudenmessschaltung erhaltenen Amplitudenausgangssignale mit der Sollamplitude zu vergleichen, indem mittels des Addierers eine Differenz zwischen der Höhe der erhaltenen Amplitudenausgangssignale und der Sollamplitude gebildet wird. Wenn die aktive elektronische Einrichtung einen elektrisch regelbaren Widerstand umfasst, ist der Amplitudenstabilisierungsregler bevorzugt mit dem regelbaren Widerstand elektrisch verbunden, um diesen mittels eines elektrischen Steuersignals anzusteuern, wobei der Amplitudenstabilisierungsregler insbesondere mit dem Gate-Anschluss eines Transistors verbunden ist, um an diesen eine elektrische Steuerspannung anzulegen. Ein Regelkreis ist insbesondere zweckmäßig, wenn es sich bei der erfindungsgemäßen Vorrichtung um eine Referenz-Vorrichtung handelt, insbesondere einen Referenz-RASER, welcher durch eine RASER-Oszillation mit konstanter Amplitude charakterisiert ist. Eine solche stabile RASER-Oszillation kann als Referenz zur Kompensation von Magnetfeld- bzw. Frequenzschwankungen einer Haupt-Vorrichtung, insbesondere eines RASER/NMR-Spektrometers, dienen. Ein Referenz-RASER kann somit ein amplitudenstabilisiertes Referenzsignal liefern.

Bei der Schwingkreisspule der erfindungsgemäßen Vorrichtung kann es sich um eine kombinierte Sende-/Empfangsspule handeln. Dies ist insbesondere zweckmäßig, wenn es sich bei der erfindungsgemäßen Vorrichtung um eine Referenz-Vorrichtung handelt. Auf diese Weise lässt sich die Vorrichtung verglichen mit einer größeren Anzahl von Spulen kostengünstiger und kompakter herstellen. Bevorzugt handelt es sich bei der Schwingkreisspule der erfindungsgemäßen Vorrichtung um eine getrennte Sende-/Empfangsspule, deren sensitive Achsen zumindest im Wesentlichen senkrecht aufeinander stehen und/oder zumindest im Wesentlichen senkrecht zur Richtung des Magnetfelds B₀ eines im Folgenden beschriebenen Magneten zur Erzeugung des homogenen, statischen Magnetfelds B₀ orientiert sind. Dies führt zu einem höheren SNR, da die Empfangsspule für sich allein optimiert werden kann und der Einfluss der störenden Sendespule minimal ist. Das Vorsehen einer getrennten Sende-/Empfangsspule ist insbesondere zweckmäßig, wenn es sich bei der erfindungsgemäßen Vorrichtung um eine Haupt-Vorrichtung beziehungsweise ein RASER/NMR-Spektrometer handelt. Unter dem Begriff "sensitive Achse" kann im Allgemeinen insbesondere die Vorzugsrichtung eines Messinstruments, beispielsweise einer Spule, in der das Messinstrument besonders sensitiv auf eine zu messende Größe, beispielsweise rotierende Spins, reagiert, verstanden werden. Im Falle einer Zylinderspule ist die sensitive Achse vorzugsweise die Zylinderachse. Es können ein ganzes Array von Empfangsspulen realisiert werden, unter Benutzung nur einer Sendespule. Falls die erfindungsgemäße Vorrichtung nur eine Empfangsspule umfasst, lässt sich diese jedoch verglichen mit einem Array von Empfangsspulen kostengünstiger herstellen. Insbesondere RASER-Anwendungen können auch ohne separate Sendespule auskommen, da die Empfangsspule alleine mit der Probe das NMR-Rasersignal erzeugt.

Vorzugsweise ist ein Magnet vorgesehen, der dazu ausgebildet und/oder eingerichtet ist, ein homogenes, statisches Magnetfeld zu erzeugen, und ist die Schwingkreisspule innerhalb dieses Magnetfelds angeordnet, um zumindest einen Teil der Kernspins von Atomen und/oder Molekülen eines in dem Aufnahmeraum der Schwingkreisspule angeordneten aktiven Mediums in Richtung des Magnetfelds des Magneten auszurichten und/oder zu polarisieren. Dabei wird unter Polarisation P der Grad der Ausrichtung von Kernspins in dem aktiven Medium verstanden. Bei dem Magneten kann es sich um einen Elektromagneten, insbesondere einen Elektromagneten mit einem entsprechenden Shim-Spulensatz, mit einer bevorzugt zylindrischen Magnetspule handeln, die einen insbesondere zylindrischen Spulenaufnahmeraum umgibt, innerhalb dessen die Schwingkreisspule angeordnet ist. Vorteilhafterweise sind der Magnet und die Schwingkreisspule derart zueinander ausgerichtet, dass das Magnetfeld des Magneten zumindest im Wesentlichen senkrecht zu dem durch die Schwingkreisspule erzeugten Wechselfeld verläuft, d.h. die sensitive Achse des Elektromagneten und die sensitive Achse der Schwingkreisspule zumindest im Wesentlichen senkrecht aufeinander stehen. Zweckmäßigerweise weist das Magnetfeld des Magneten eine Homogenität kleiner als 1 ppm, bevorzugt kleiner oder gleich 0,01 ppm, und/oder eine magnetische Flussdichte von mindestens 100 Gauß und/oder zwischen 1 und 200 Gauß, insbesondere von 100 Gauß auf. Eine ausreichende Homogenität des Magnetfeldes ist bei Durchführung von NMR- und/oder RASER--Untersuchungen wichtig, da ein inhomogenes Magnetfeld sowohl zu einer Verbreiterung der NMR-Linien im NMR-Spektrum und somit insbesondere zu einer Verschlechterung der Auflösung im NMR-Spektrum, als auch zu einer Erhöhung der RASER-Schwelle (P_{X} ∼ 1/T₂*) führt.. Die erfindungsgemäße Vorrichtung muss jedoch keinen Magneten umfassen, denn prinzipiell ist es auch möglich, beispielsweise das Erdmagnetfeld zu nutzen. Im Falle eines Elektromagneten schwankt das von diesem erzeugte Magnetfeld insbesondere aufgrund von Schwankungen der Stromversorgung des Elektromagneten in einer Größenordnung von 1 ppm/h.

Vorteilhaft umfasst die elektrische Schaltung, bevorzugt der elektrische Schwingkreis eine insbesondere verlustarme Hilfsspule, insbesondere eine Ferritspule, die einen insbesondere verlustarmen Ferritkern aufweist, wobei die Hilfsspule vorzugsweise in Reihe mit der Schwingkreisspule und dem Kondensator geschaltet ist. Hierbei kann die Hilfsspule ein Bestandteil des Schwingkreises sein. Die Hilfsspule kann zusammen mit dem Kondensator einen externen Resonator bilden, der zusammen mit der Schwingkreisspule eine erhöhte Güte Q und somit ein erhöhtes SNR aufweist. Ein externer Resonator der zuvor beschriebenen Art ist auch unter EHQE-Resonator bekannt, wobei der Ausdruck "EHQE" für "External High-Quality-factor Enhanced" steht. Zweckmäßigerweise ist die Hilfsspule, insbesondere Ferritspule mit Ferritkern, möglichst weit von der Schwingkreisspule entfernt positioniert, um magnetische Störungen/Beeinflussungen des homogenen B₀-Feldes des Magneten, insbesondere Elektromagneten, zu vermeiden. Die Hilfsspule kann durch eine elektrische und/oder magnetische Abschirmung abgeschirmt sein, wobei die Abschirmung vorzugsweise als insbesondere doppelwandige Kammer oder Dose, innerhalb der sich die Hilfsspule befindet, ausgebildet ist oder eine solche umfasst. Hierbei kann die Abschirmung aus einem Material bestehen, das Mu-Metall oder Eisen umfasst. Auf diese Weise wird die Hilfsspule, insbesondere Ferritspule mitsamt Ferrit, von Magnetfeldern, insbesondere einem homogenen, statischen Magnetfeld, welches beispielsweise bei NMR- und/oder NMR-RASER-Untersuchungen eingesetzt wird, abgeschirmt. Dies trägt ebenfalls zu einer Verbesserung des Signal-Rausch-Verhältnisses bei. Elektrische Leitungen zwischen der Schwingkreisspule und der Hilfsspule und/oder dem Kondensator können als Twisted-Pair-Leitung oder als Lecherleitung ausgebildet sein, wodurch ein besserer Schutz gegenüber elektrischen und/oder magnetischen Störfeldern bereitgestellt wird.

Wenn in dem von der Schwingkreisspule umgebenen Aufnahmeraum ein aktives Medium angeordnet ist, kann dieses beispielsweise organische Moleküle, RASER-fähige Moleküle, ein organisches Lösungsmittel, insbesondere Methanol, bevorzugt d4-Methanol, Pyridin C₅H₅N, Acetonitril CH₃CN und/oder mit Parawasserstoff hyperpolarisierbare Substanzen, d.h. PHIP-aktive oder SABRE-aktive Substanzen, umfassen. SABRE-hyperpolarisierbare Substanzen umfassen stickstoffhaltige Verbindungen und/oder eine, insbesondere mehrere N-heterozyklische Verbindungen und/oder Nitrile. Auch kann vorgesehen sein, dass das aktive Medium, insbesondere aktive PHIP/SABRE-Medium, einen Katalysator, beispielsweise einen geeigneten Ir-Katalysator (z.B. IMes), insbesondere einen [IrCI(COD(IMes))]-Katalysator, oder einen anderen Katalysator auf Iridium- oder Rhodium-Basis, umfasst. Falls das aktive Medium durch Einleiten von Para-Wasserstoff in das aktive Medium gepumpt wird, können an den Katalysator Atome und/oder Moleküle des aktiven Mediums sowie der Para-Wasserstoff andocken. Der Ausdruck "PHIP" steht für "para hydrogen induced polarization" und der Ausdruck "SABRE" steht für "signal amplification by reversible exchange". Pyridin C₅H₅N und Acetonitril CH₃CN sind Beispiele für organische Moleküle. Das aktive Medium kann auch ein Feststoff sein, der insbesondere Soft-Polymere umfasst oder aus Soft-Polymeren besteht. Bevorzugt ist das aktive Medium eine Flüssigkeit, die aktive Zielatome und/oder aktive Zielmoleküle, vorzugsweise Pyridin C₅H₅N oder Acetonitril CH₃CN, umfasst, die insbesondere in einem Lösungsmittel, vorzugsweise Methanol, gelöst sind. Im Falle einer Flüssigkeit lassen sich im Vergleich zu einem gasförmigen Medium hohe Spindichten erzielen und im Vergleich zu einem Feststoff ist die transversale Relaxationszeit T₂ erheblich länger (T₂ ∼ 1s für Protonen) und damit ist die RASER-Schwelle wesentlich niedriger (Ps ∼ 1/(T₂ • Q)).

Gemäß einer weiteren Ausgestaltung ist die Vorrichtung dazu ausgebildet und/oder eingerichtet, einen Hochfrequenz-Anregungsimpuls in Form eines zeitlich begrenzten hochfrequenten magnetischen Wechselfeldes zu erzeugen, dem ein in dem Aufnahmeraum der Schwingkreisspule angeordnetes oder anordenbares aktives Medium ausgesetzt ist, um von dem hochfrequenten magnetischen Wechselfeld angeregt zu werden. Auf diese Weise kann die erfindungsgemäße Vorrichtung in einem Standard-NMR-Betrieb betrieben werden.

Grundsätzlich kann die elektrische Schaltung der Vorrichtung dazu ausgebildet und/oder eingerichtet sein, die Schwingkreisspule mit einer externen Versorgungsspannung zu speisen, um den Hochfrequenz-Anregungsimpuls mittels der Schwingkreisspule zu erzeugen. In einer bevorzugten Ausgestaltung weist die elektrische Schaltung zusätzlich zu der Schwingkreisspule eine insbesondere als Sattelspule ausgebildete Hochfrequenzanregungsspule auf, die dazu ausgebildet und/oder eingerichtet ist, den Hochfrequenz-Anregungsimpuls zu erzeugen. Die sensitiven Achsen der Schwingkreisspule und der Hochfrequenzanregungsspule stehen vorzugsweise zumindest im Wesentlichen senkrecht aufeinander. Ein Vorteil einer separaten Hochfrequenzanregungsspule gegenüber der Schwingkreisspule als kombinierte Sende-/Empfangsspule ist, dass es dadurch möglich ist, den Schwingkreis, insbesondere EHQE-Schwingkreis, unabhängig von der Hochfrequenzanregungsspule zu optimieren. Insbesondere bei niedrigen Frequenzen (< 1 MHz) kann man die Hochfrequenz ohne Abstimmung und Anpassung breitbandig in die Probe einstrahlen. Dies bedeutet eine erhebliche Vereinfachung und Einsparung von Hardware-Komponenten. Da der elektrische Schwingkreis der erfindungsgemäßen Vorrichtung während des Betriebs der Vorrichtung aktiv entdämpft wird und somit eine hohe Güte aufweist, ist dieser sehr empfindlich auf äußere Störungen, insbesondere bei einer Pulsanregung. Das Problem der Totzeit, d.h. lange Nachschwingzeit, nach einem Sendepuls kann durch eine bestmögliche mechanische und elektrische Entkopplung zwischen dem Sendekreis (Hochfrequenzanregungsspule) und der insbesondere dazu orthogonalen Schwingkreisspule, optional in Kombination mit einer Güteschaltung zur schnellstmöglichen Ableitung der eingespeisten Sendeenergie im Resonator (Q-switch), gelöst werden. Dies ist nicht zu vergleichen mit einer Standard-NMR-Spektroskopie-Vorrichtung, wo Sende- und Empfangskanal mit einer einzigen Spule realisiert und mit einer T-Brücke getrennt werden können.

Eine weitere Ausgestaltung der Erfindung zeichnet sich dadurch aus, dass eine Pump-Einrichtung vorgesehen ist, die dazu ausgebildet und/oder eingerichtet sein, Kernspins von Atomen und/oder Molekülen eines in dem Aufnahmeraum angeordneten oder anordenbaren aktives Mediums insbesondere mittels eines Hyperpolarisationsverfahrens, wie etwa SABRE, DNP, SEOP, SPINOE und/oder PHIP, in einen Zustand negativer oder positiver Kernspinpolarisation zu pumpen. Hierdurch werden nicht Boltzmanngleichgewichtszustände hergestellt. Beispielsweise wird im Falle einer negativen Kernspinpolarisation eine Besetzungsinversion von Energiezuständen der Atome und/oder Moleküle hergestellt. Im Falle eines SEOP-Verfahrens können geeignete zirkular polarisierte Laser verwendet werden, die Rb-Metalldampf beispielsweise bei ca. 180 °C in zumindest einer kleinen Glaszelle optisch pumpen. Die zumindest eine Glaszelle kann hierbei eine Größe von wenigen cm³ oder mm³, beispielsweise von 0,2 cm³, aufweisen. Das aktive Medium kann sich in der zumindest einen Glaszelle befinden, wobei insbesondere Atome des aktiven Mediums in das Glas der Glaszelle eingeschmolzen sein können. Beispielsweise befinden sich in einer Glaszelle einige bar ³He-Gas und etwa 10 mbar N₂-Gas (Quenschgas). Die zumindest eine Glaszelle befindet sich zweckmäßigerweise innerhalb des Aufnahmeraums der Schwingkreisspule. Die Pump-Einrichtung kann vorzugsweise dazu ausgebildet und/oder eingerichtet sein, Kernspins durch Einleiten von Para-Wasserstoffgas in das aktive Medium, das in diesem Fall einen Katalysator, beispielsweise auf Ir-Basis, und Zielmoleküle, beispielsweise Acetonitril, umfasst, zu pumpen. Die bei dem sogenannten SABRE-Mechanismus erzeugte negative Polarisation ist eine Möglichkeit der Besetzungsinversion beziehungsweise Populationsinversion. Die Pump-Einrichtung kann so ausgebildet und/oder eingerichtet sein, dass der Betrag der von ihr bewirkten Kernspinpolarisation |P| ∼ 10⁻³ -10⁻¹ mehrere Größenordnungen höher als die durch Magnetfelder erzeugte thermische Kernspinpolarisation ist. Ein negatives P entspricht einer negativen Spintemperatur, d.h. das höhere Energieniveau, welches ein Kernspin einnehmen kann, ist stärker besetzt als das niedrigere Energieniveau. Auf diese Weise wird eine RASER- oder NMR-RASER-Vorrichtung geschaffen, die mit einer erfindungsgemäßen aktiven elektronischen Einrichtung zur aktiven Entdämpfung des Schwingkreises versehen ist. Durch die von der aktiven elektronischen Einrichtung bewirkte aktive Entdämpfung wird die Güte des Schwingkreises erhöht. Da die RASER-Schwelle umgekehrt proportional zur Güte ist, können auch Moleküle, die nur wenig negative Kernspinpolarisation beispielsweise durch SABRE erlangen, oder Moleküle einer selten vorkommenden Kernspinspezies zur RASER-Aktivität gebracht werden. Mit anderen Worten wird bei einer Erhöhung der Güte bei gleichbleibender Pumpleistung die RASER-Schwelle herabgesetzt, d.h. die Vorrichtung schwingt leichter an. Dies erhöht das Anwendungsspektrum erheblich. Zum Beispiel können verglichen mit der vorbekannten NMR-RASER-Vorrichtung geringere Konzentrationen des aktiven Mediums oder eines NMR-aktiven Stoffs/Atoms/Moleküls innerhalb des aktiven Mediums untersucht werden, d.h. eine sogenannte Spurenanalyse durchgeführt werden. Dies stellt einen erheblichen Vorteil gegenüber dem Stand der Technik dar. Das verglichen mit den vorbekannten Vorrichtungen sehr große SNR der erfindungsgemäßen Vorrichtung erlaubt es auch Kerne mit sehr kleinem gyromagnetischen Verhältnis (z.B. ¹⁵N, ¹⁰³Rh, ⁵⁷Fe) in Echtzeit zu detektieren. Dies ist selbst mit den stärksten supraleitenden Magneten nicht möglich.

Es ist somit offensichtlich, dass sich für die erfindungsgemäße Vorrichtung nie dagewesene Einsatzmöglichkeiten eröffnen. Zudem werden durch die aktive Entdämpfung des Schwingkreises quasi beliebig lange RASER-NMR-Messungen ermöglicht.

Die zuvor erwähnte Aufgabe wird erfindungsgemäß auch durch einen Magnetfeldsensor zur Messung eines Magnetfelds, der die zuvor beschriebene erfindungsgemäße Vorrichtung umfasst oder daraus besteht, gelöst, wobei insbesondere in dem Aufnahmeraum ein aktives Medium angeordnet oder anordenbar ist, das bevorzugt nur aktive Moleküle einer Sorte aufweist. Beim Betrieb des Magnetfeldsensors wird eine durch das zu messende Magnetfeld veränderte Resonanzfrequenz und darauf basierend das Magnetfeld gemessen. Falls die Vorrichtung des Magnetfeldsensors einen Regelkreis umfasst, kann dieser insbesondere zur aktiven Stabilisierung der Amplitude einer einzelnen RASER-Mode der Vorrichtung dienen, wodurch eine erhebliche Verbesserung der Präzision der Frequenz und Phase des gemessenen Magnetfelds möglich ist. Mit aktiven Molekülen einer Sorte ist gemeint, dass nicht verschiedene Moleküle, sondern dieselben vorgesehen sind.

Die zuvor beschriebene erfindungsgemäße Vorrichtung kann auch Bestandteil, insbesondere alleiniger Bestandteil eines Gerätes zur Detektierung von Materialien und/oder zur Messung oder Untersuchung von Molekülstrukturen und/oder zur Vermessung von Kernen für den Metabolismus und/oder zum Reaktions-Monitoring sein. In Frage kommende Kerne für den Metabolismus sind beispielsweise ⁵⁷Fe oder ³³S, ¹⁵N.

Weiterer Gegenstand der Erfindung ist die Verwendung der zuvor beschriebenen erfindungsgemäßen Vorrichtung für Magnetfeldmessungen und/oder für RASER-Anwendungen und/oder für NMR-Spektroskopie und/oder zur Detektierung von Materialien und/oder zur Messung oder Untersuchung von Molekülstrukturen und/oder zur Vermessung von Kernen für den Metabolismus und/oder beim Reaktions-Monitoring gelöst.

Darüber hinaus wird die zuvor erwähnte Aufgabe erfindungsgemäß durch ein Verfahren zum Betrieb einer erfindungsgemäßen Vorrichtung, die eine Pump-Einrichtung umfasst, gelöst, bei dem
a) ein aktives Medium innerhalb des Aufnahmeraums der Schwingkreisspule angeordnet ist oder wird und einem homogenen, statischen Magnetfeld ausgesetzt wird, wodurch zumindest ein Teil der Kernspins von Atomen und/oder Molekülen des aktiven Mediums in Richtung des homogenen, statischen Magnetfelds ausgerichtet wird;
b) Kernspins des aktiven Mediums mittels der Pump-Einrichtung in einen Zustand negativer oder positiver Kernspinpolarisation gepumpt werden,,
c) das aktive Medium insbesondere spontan und/oder stimuliert elektromagnetische Strahlung emittiert, die in der Schwingkreisspule eine insbesondere zeitlich veränderliche Spannung induziert, wobei erfindungsgemäß
d) der elektrische Schwingkreis durch die aktive elektronische Einrichtung aktiv entdämpft wird, wodurch die RASER-Schwelle, ab der der elektrische Schwingkreis zu schwingen beginnt, herabgesetzt wird.

Durch das Pumpen werden nicht Boltzmanngleichgewichtszustände hergestellt. Beispielsweise wird im Falle einer negativen Kernspinpolarisation eine Besetzungsinversion hergestellt. Im Zusammenhang mit dem Begriff "Besetzungsinversion" kann auch von Überbesetzung von Energiezuständen gesprochen werden.

In Schritt c) erfolgt die Ankopplung des Schwingkreises an das aktive Medium über die Schwingkreisspule, in der das aktive Medium angeordnet ist. Genauer gesagt wird durch Faradayinduktion eine Spannung in der Schwingkreisspule induziert.

Hierbei kann in Schritt d) die Stärke der von der aktiven elektronischen Einrichtung bewirkten Entdämpfung insbesondere durch Einstellung, bevorzugt Regelung einer externen elektrischen Energieversorgung und/oder eines regelbaren Widerstands der aktiven elektronischen Einrichtung eingestellt, insbesondere geregelt werden.

Zweckmäßigerweise wird in Schritt d) die Stärke der von der aktiven elektronischen Einrichtung bewirkten Entdämpfung so eingestellt, dass die Anordnung aus dem elektrischen Schwingkreis und dem aktiven Medium bevorzugt kontinuierliche RASER-Schwingungen ausführt, wobei hierzu insbesondere die bei dem verwendeten aktiven Medium und bei dem getätigten Pumpaufwand in der Schwingkreisspule induzierte Spannung führt.

Mit anderen Worten beginnt der elektrische Schwingkreis beziehungsweise die Anordnung aus dem elektrischen Schwingkreis und dem aktiven Medium insbesondere aufgrund von thermischen Fluktuationen zu oszillieren, sobald die Güte des elektrischen Schwingkreises durch die eingestellte aktive Entdämpfung ausreichend hoch ist, sodass die RASER-Schwelle überschritten wird.

Zweckmäßigerweise fungiert die Schwingkreisspule während der RASER-Schwingungen als Sende- und Empfangsspule, wobei die Schwingkreisspule als Sendespule elektromagnetische Strahlung erzeugt, der das aktive Medium ausgesetzt wird und die wiederum eine stimulierte Emission von elektromagnetischer Strahlung aus dem aktiven Medium bewirkt, die wiederum in der Schwingkreisspule als Empfangsspule eine Spannung induziert.

Somit werden die ohmschen Verluste des Schwingkreises sowohl durch stimulierte Emission des aktiven Mediums, insbesondere bei kernmagnetischen Übergängen, als auch durch die aktive Entdämpfung mittels der aktiven elektronischen Einrichtung kompensiert. Sobald die RASER-Schwelle durch die aktive Entdämpfung ausreichend abgesenkt und eine Besetzungsinversion hergestellt wurde, beginnt der elektrische Schwingkreis aufgrund von thermischen Fluktuationen und/oder spontaner Emission zu schwingen. Der elektrische Schwingkreis wird dann insbesondere durch die aktive elektronische Einrichtung entdämpft. Falls der getätigte Pumpaufwand und somit die Anzahl der stimulierten Emissionen des gepumpten aktiven Mediums pro Zeit zu gering ist, um die RASER-Schwelle zu überwinden, und die gewählte Stärke der aktiven Entdämpfung nicht in der Lage ist, dies zu kompensieren, wird der Schwingkreis der RASER- oder NMR-RASER-Vorrichtung nicht anschwingen, sondern nur als Schwingkreis mit höherer Güte wirken.

Bevorzugt wird eine erfindungsgemäße Vorrichtung, bevorzugt eine Referenz-Vorrichtung, insbesondere ein Referenz-RASER, mit einem Regelkreis für die aktive elektronische Einrichtung, der insbesondere eine Amplitudenmessschaltung, einen Amplitudenstabilisierungsregler und eine Auswerteeinheit umfasst, bereitgestellt und wird in Schritt d) die Stärke der von der aktiven elektronischen Einrichtung bewirkten Entdämpfung und/oder ein negativer elektrischer Widerstand oder eine negative Impedanz der aktiven elektronischen Einrichtung durch den Regelkreis kontinuierlich oder in vorbestimmten, insbesondere gleichmäßigen Zeitabständen nachgeregelt, wodurch die Schwingungsamplitude des elektrischen Schwingkreises stabilisiert wird. Hierfür kann in Schritt d) durch den Regelkreis die Schwingungsamplitude des elektrischen Schwingkreises erfasst, mit einer Sollamplitude verglichen und die Schwingungsamplitude unter Berücksichtigung des Ergebnisses des Vergleichs nachgeregelt werden, indem die von der aktiven elektronischen Einrichtung bewirkte Entdämpfung und/oder ein negativer elektrischer Widerstand oder eine negative Impedanz der aktiven elektronischen Einrichtung nachgeregelt wird. Konkret kann in Schritt d) mit der Amplitudenmessschaltung des Regelkreises ein Ausgangszeitsignal, insbesondere Spannungszeitsignal, des elektrischen Schwingkreises abgegriffen werden, die Amplitude des abgegriffenen Ausgangszeitsignals als Schwingungsamplitude des elektrischen Schwingkreises kontinuierlich und/oder zu vorgegebenen, bevorzugt gleichmäßig beabstandeten Zeitpunkten erfasst werden und zu der erfassten Schwingungsamplitude korrespondierende Amplitudenausgangssignale an eine Auswerteeinheit des Regelkreises übermittelt werden. Mit der Auswerteeinheit kann die Höhe der von der Amplitudenmessschaltung erhaltenen Amplitudenausgangssignale mit einer Sollamplitude verglichen und basierend auf diesem Vergleich bestimmt werden, in welchem Maße es notwendig ist, die Schwingungsamplitude nachzuregeln. Darüber hinaus kann mit der Auswerteeinheit ein entsprechendes Regelungsanweisungssignal an den Amplitudenstabilisierungsregler des Regelkreises übermittelt werden. Mit dem Amplitudenstabilisierungsregler kann ein elektrisch regelbarer Widerstand der aktiven elektronischen Einrichtung unter Berücksichtigung des von der Auswerteeinheit erhaltenen Regelungsanweisungssignals mittels eines elektrischen Steuersignals angesteuert werden, insbesondere eine elektrische Steuerspannung an den Gate-Anschluss des Transistors angelegt werden, um den elektrisch regelbaren Widerstand einzustellen und/oder nachzuregeln. Ein Referenz-RASER kann somit ein amplitudenstabilisiertes Referenzsignal bereitstellen.

Bei dem erfindungsgemäßen Verfahren kann jedoch auch eine erfindungsgemäße Vorrichtung ohne Regelkreis bereitgestellt werden. Beispielsweise kann eine Haupt-Vorrichtung, insbesondere ein RASER/NMR-Spektrometer, bereitgestellt werden, die insbesondere in einem RASER-Betrieb nicht amplitudenstabilisiert ist. Die RASER-Schwelle (beziehungsweise die Güte Q) einer solchen Haupt-Vorrichtung kann beispielsweise über einen elektrisch regelbaren Widerstand der aktiven elektronischen Einrichtung der Haupt-Vorrichtung innerhalb eines großen Bereiches (10 < Q < 107) gesteuert werden. Darüber hinaus kann die Frequenz einer solchen Haupt-Vorrichtung mittels des insbesondere einstellbar ausgebildeten Kondensators des elektrischen Schwingkreises der Haupt-Vorrichtung variiert werden. Ein mittels einer solchen Haupt-Vorrichtung erfasstes multi- oder single-mode RASER-Signal eines RASER-aktiven Moleküls kann beispielsweise durch eine Fouriertransformation analysiert werden, wodurch NMR-Information (chemische Verschiebungen und J-Kopplungen) erhalten wird.

In Schritt b) können Kernspins von Atomen und/oder Molekülen des aktiven Mediums mittels eines mit Hilfe der Pump-Einrichtung durchgeführten Hyperpolarisationsverfahrens, wie etwa mittels der SABRE-, PHIP-, SEOP-, SPINOE- und/oder DNP-Technologie, in einen Zustand mit negativer oder positiver Kernspinpolarisation gepumpt werden. Insbesondere bei PHIP und SABRE werden Kernspins durch Einleiten von Para-Wasserstoffgas, d.h. gasförmigem Para-Wasserstoff, insbesondere in Anwesenheit eines SABRE-Katalysators in das aktive Medium in einen Zustand mit negativer Kernspinpolarisation gepumpt. Beispielsweise werden durch das Pumpen die Kernspins und/oder die Singlet-Magnetisierung des Para-Wasserstoffs auf die Kernmagnetisierung des aktiven Mediums oder darin enthaltener aktiver Atome und/oder Moleküle übertragen und in detektierbare Dipol-Magnetisierung umgewandelt. Hierbei steht Ausdruck "SABRE" für "signal amplification by reversible exchange". Der Ausdruck "SEOP" steht für "Spin Exchange Optical Pumping", der Ausdruck "DNP" steht für "Dynamic Nuclear Polarisation" und der Ausdruck "PHIP" steht für "parahydrogen induced polarization".

Die Erfindung betrifft auch ein Verfahren zum Betrieb einer erfindungsgemäßen Vorrichtung, beispielsweise einer Haupt-Vorrichtung, insbesondere eines RASER/NMR-Spektrometers, die dazu ausgebildet und/oder eingerichtet ist, einen Hochfrequenz-Anregungsimpuls insbesondere mittels einer separaten Hochfrequenzanregungsspule zu erzeugen, bei dem
a) ein aktives Medium innerhalb des Aufnahmeraums der Schwingkreisspule angeordnet ist oder wird und einem homogenen, statischen Magnetfelds ausgesetzt wird, wobei zumindest ein Teil der Kernspins von Atomen und/oder Molekülen des aktiven Mediums in Richtung des homogenen, statischen Magnetfelds ausgerichtet wird;
b) ein Hochfrequenz-Anregungsimpuls in Form eines zeitlich begrenzten hochfrequenten magnetischen Wechselfeldes erzeugt wird, und das aktive Medium dem Hochfrequenz-Anregungsimpuls ausgesetzt wird, sodass das aktive Medium von diesem angeregt wird;
c) das angeregte aktive Medium bevorzugt durch Faradayinduktion eine Spannung in der Schwingkreisspule induziert, wobei erfindungsgemäß
d) der elektrische Schwingkreis durch die aktive elektronische Einrichtung aktiv entdämpft wird.

Bevorzugt wird in Schritt d) der elektrische Schwingkreis derart entdämpft, dass der elektrische Schwingkreis mit seiner hohen Güte nicht, vorzugsweise gerade nicht, insbesondere aufgrund von thermischen oder Quantenfluktuationen, zu schwingen beginnt. Auf diese Weise gibt es keine oder nur eine sehr geringe Rückkopplung, d.h. die Schwingkreisspule erzeugt ihrerseits kein Magnetfeld und/oder emittiert ihrerseits keine elektromagnetische Strahlung in Richtung des aktiven Mediums.

In Schritt d) kann die Stärke der von der aktiven elektronischen Einrichtung bewirkten Entdämpfung durch Einstellung, insbesondere Regelung eines regelbaren Widerstands der aktiven elektronischen Einrichtung eingestellt, insbesondere geregelt werden.

Vorteilhafterweise wird in Schritt b) der Hochfrequenz-Anregungsimpuls mittels der Schwingkreisspule erzeugt, indem die Schwingkreisspule mit einer externen Hochfrequenz-Versorgungsspannung gespeist wird, und/oder wird der Hochfrequenz-Anregungsimpuls mittels Anlegen einer Spannung an eine separate Hochfrequenzanregungsspule erzeugt.

Bei Verwendung einer separaten Hochfrequenzanregungsspule verläuft das Magnetfeld der Hochfrequenzanregungsspule bevorzugt senkrecht zur Spulenachse der Schwingkreisspule und das homogene, statische Magnetfeld wiederum bevorzugt senkrecht zu dem Magnetfeld der Hochfrequenzanregungsspule und zu der Spulenachse der Schwingkreisspule.

Bei beiden zuvor beschriebenen erfindungsgemäßen Verfahren kann in Schritt d) die aktive Entdämpfung beispielsweise erfolgen, indem die aktive elektronische Einrichtung die ohmschen Verluste des elektrischen Schwingkreises reduziert und dadurch die Güte des elektrischen Schwingkreises erhöht und die RASER-Schwelle erniedrigt. Auch kann bei beiden Verfahren in Schritt d) die aktive elektronische Einrichtung mit externer elektrischer Energie versorgt werden, insbesondere eine externe Versorgungsspannung an einen Operationsverstärker der aktiven elektronischen Einrichtung angelegt werden, und die aktive Entdämpfung erfolgen, indem dem elektrischen Schwingkreis über die aktive elektronische Einrichtung externe elektrische Energie zugeführt wird. Darüber hinaus kann bei beiden Verfahren in Schritt a) das homogene, statische Magnetfeld mittels eines Magneten, insbesondere eines Elektromagneten erzeugt werden.

Eine erfindungsgemäße Vorrichtung, die sowohl eine Pump-Einrichtung umfasst als auch dazu ausgebildet und/oder eingerichtet ist, einen Hochfrequenz-Anregungsimpuls insbesondere mittels einer separaten Hochfrequenzanregungsspule zu erzeugen, kann betrieben werden, indem von jedem der beiden zuvor beschriebenen erfindungsgemäßen Verfahren zumindest einige Verfahrensschritte hintereinander und/oder gleichzeitig durchgeführt werden, wie dies im Folgenden für den Betrieb des nachfolgend beschriebenen erfindungsgemäßen Systems beschrieben ist.

Darüber hinaus betrifft die Erfindung ein Verfahren zur Bestimmung der Struktur von Molekülen eines aktiven Mediums, dessen Schritte auch Bestandteil eines der beiden zuvor beschriebenen erfindungsgemäßen Verfahren sein können, bei dem
a) eine erfindungsgemäße Vorrichtung, beispielsweise eine Haupt-Vorrichtung, bereitgestellt wird, die mit einer Pump-Einrichtung versehen ist, und deren aktive elektronische Einrichtung derart ausgebildet und/oder eingerichtet ist, dass die Stärke der von ihr bewirkten Entdämpfung einstellbar ist,
b) in dem von der Schwingkreisspule der Vorrichtung umgebenen Aufnahmeraum ein aktives Medium, welches Moleküle mit häufigen X-Kernen, wie etwa ¹H-Kernen, mit X-Kernspins und seltenen X-Kernen, wie etwa ¹³C-, ¹⁵N-, ²⁹Si-, ³¹Ph- und/oder ⁵⁷Fe-Kernen, mit X-Kernspins umfasst, angeordnet und insbesondere einem homogenen, statischen Magnetfeld ausgesetzt wird, wodurch zumindest ein Teil der X-Kernspins in Richtung des homogenen, statischen Magnetfelds ausgerichtet wird;
c) X-Kernspins des aktiven Mediums mittels der Pump-Einrichtung in einen Zustand negativer Kernspinpolarisation gepumpt werden;
d) eine RASER-Aktivität mindestens eines häufigen X-Kerns erzwungen wird, indem mit der aktiven elektronischen Einrichtung die Güte der Vorrichtung, insbesondere des elektrischen Schwingkreises der Vorrichtung, soweit erhöht wird, bis die RASER-Aktivität des häufigen X-Kerns einsetzt, wobei sich neben dem mindestens einen sich in einem RASER-aktiven Zustand befindlichen häufigen X-Kern häufige und/oder seltene X-Kerne in einem RASER-inaktiven Zustand befinden; und
e) wenigstens eine, bevorzugt alle RASER-aktiven Resonanzen/Linien, welche homo- und hetero-nukleare J-Kopplungen zwischen dem mindestens einen RASER-aktiven häufigen X-Kern und den RASER-inaktiven häufigen und/oder RASER-inaktiven seltenen X-Kernen widerspiegeln, durch einen insbesondere schrittweisen Scan mit vorgegebenen Frequenzintervallen in einem vorgegebenen Frequenzbereich nahe der Resonanzfrequenz des häufigen X-Kerns, wobei die Frequenz insbesondere durch Veränderung des Wertes eines einstellbar ausgebildeten Kondensators variiert wird, gemessen werden, um die Struktur der Moleküle zu bestimmen. Insbesondere kann bei jeder eingestellten Frequenz die Güte der Vorrichtung, bevorzugt des elektrischen Schwingkreises der Vorrichtung, mit der aktiven elektronischen Einrichtung variiert, insbesondere schrittweise erhöht werden.

Die Ausdrücke "häufig" und "selten" beziehen sich insbesondere auf die natürliche Häufigkeit. Der Ausdruck "sich in einem RASER-(in)aktiven Zustand befindlich" bedeutet "RASER-(in)aktiv". Ein wesentlicher Vorteil des zuletzt beschriebenen Verfahrens ist, dass dieses ohne teure Isotopen-Anreicherungsverfahren der seltenen X-Kerne funktioniert, also mit Molekülen mit seltenen X-Kernen in natürlicher Häufigkeit.

Außerdem betrifft die Erfindung ein Verfahren zur Bestimmung der Struktur von Molekülen eines aktiven Mediums, dessen Schritte auch Bestandteil eines der zuvor beschriebenen erfindungsgemäßen Verfahren sein können, bei dem
a) eine erfindungsgemäße Vorrichtung, beispielsweise eine Haupt-Vorrichtung, bereitgestellt wird, die mit einer Pump-Einrichtung versehen ist, und deren aktive elektronische Einrichtung derart ausgebildet und/oder eingerichtet ist, dass die Stärke der von ihr bewirkten Entdämpfung einstellbar ist;
b) in dem von der Schwingkreisspule der Vorrichtung umgebenen Aufnahmeraum ein aktives Medium, welches Moleküle mit X-Kernspins umfasst, angeordnet und insbesondere einem homogenen, statischen Magnetfeld ausgesetzt wird, wodurch zumindest ein Teil der X-Kernspins in Richtung des homogenen, statischen Magnetfelds ausgerichtet wird;
c) X-Kernspins des aktiven Mediums mittels der Pump-Einrichtung in einen Zustand negativer Kernspinpolarisation gepumpt werden;
d) eine RASER-Aktivität einer verglichen mit zumindest einer weiteren Linie großen Linie erzwungen wird, wobei insbesondere die weitere Linie verglichen mit der großen Linie eine um den Faktor Eintausend kleinere Amplitude aufweist, indem
   d1) der elektrische Schwingkreis insbesondere mittels eines Einstellens des in diesem Fall einstellbar ausgebildeten Kondensators auf das Maximum der großen Linie eingestimmt wird, und
   d2) durch eine aktive Entdämpfung des elektrischen Schwingkreises mittels der aktiven elektronischen Einrichtung die Güte der Vorrichtung, insbesondere des elektrischen Schwingkreises der Vorrichtung, soweit erhöht wird, bis die RASER-Aktivität der großen Linie einsetzt, oder die Güte auf oder oberhalb der RASER-Schwelle für die große Linie eingestellt wird, so dass die RASER-Aktivität der großen Linie einsetzt;
e) ein X-RASER-Ausgangszeitsignal insbesondere nach einem Einschwingen der RASER-Schwingung in ein stationäres Gleichgewicht an der elektrischen Schaltung, insbesondere an der aktiven elektronischen Einrichtung, abgegriffen und daraus insbesondere mittels einer Fouriertransformation ein X-RASER-Spektrum der Moleküle mit X-Kernspins erhalten wird, das insbesondere zumindest die große Linie umfasst,
f) eine RASER-Aktivität der zumindest einen weiteren Linie erzwungen wird, indem
   f1) der elektrische Schwingkreis insbesondere durch eine Veränderung des Werts des in diesem Fall einstellbar ausgebildeten Kondensators verstimmt wird, wobei der elektrische Schwingkreis auf eine Frequenz eingestimmt wird, die höher oder niedriger als die Resonanzfrequenz der großen Linie ist,
   f2) mittels der aktiven elektronischen Einrichtung die Güte der Vorrichtung (2), insbesondere des elektrischen Schwingkreises der Vorrichtung, schrittweise, insbesondere auf einen Wert von mindestens 10⁵, bevorzugt mindestens 10⁶, besonders bevorzugt mindestens 10⁷, erhöht wird, wodurch insbesondere die RASER-Schwelle der zumindest einen weiteren Linie überschritten wird, und
   f3) die Resonanzfrequenz in vorgegebenen Frequenzintervallen, beispielsweise für Q = 10⁷ in Intervallen von 0,1 Hz, schrittweise über einen vorgegebenen Frequenzbereich in der Nähe der großen Linie verstimmt wird, insbesondere indem der Wert des in diesem Fall einstellbar ausgebildeten Kondensators variiert wird, und wenn die Resonanzfrequenz der zumindest einen weiteren Linie erreicht wird, die RASER-Aktivität der zumindest einen weiteren Linie einsetzt; und
g) ein weiteres X-RASER-Ausgangszeitsignal insbesondere nach einem Einschwingen der RASER-Schwingung in ein stationäres Gleichgewicht an der elektrischen Schaltung, insbesondere an der aktiven elektronischen Einrichtung, abgegriffen und daraus insbesondere mittels einer Fouriertransformation ein weiteres X-RASER-Spektrum der Moleküle mit X-Kernspins erhalten wird, das insbesondere die große Linie und die zumindest eine weitere Linie umfasst.

Grundsätzlich ist es bei dem zuletzt beschriebenen Verfahren möglich, insbesondere vor Schritt c) oder vor Schritt d), zunächst ein X-NMR-Spektrum der Moleküle mit X-Kernspins zu bestimmen, um die ungefähre Linienposition und/oder Amplitude zumindest der größten X-Resonanz/Linie, insbesondere aller X-Resonanzen/Linien, zu erfassen. Diesbezüglich wird auf die folgende Beschreibung eines Verfahrens zum Betrieb eines erfindungsgemäßen Systems verwiesen.

Weiterer Gegenstand der Erfindung ist ein System umfassend eine erfindungsgemäße Vorrichtung, Haupt-Vorrichtung, und eine weitere erfindungsgemäße Vorrichtung, Referenz-Vorrichtung, wobei die Referenz-Vorrichtung dazu ausgebildet und/oder eingerichtet ist, ein an der Referenz-Vorrichtung erfasstes Referenz-Messsignal, insbesondere Referenz-Ausgangszeitsignal und/oder ein daraus erhaltenes Referenz-Frequenzspektrum, als Referenz zum Korrigieren von durch Magnetfeldschwankungen und/oder sonstige Umgebungsbedingungen bedingten Störungen in einem an der Haupt-Vorrichtung erfassten Haupt-Messsignal, insbesondere Haupt-Ausgangszeitsignal und/oder einem daraus erhaltenen Frequenzspektrum, bereitzustellen. Die Haupt-Vorrichtung kann dazu ausgebildet und/oder eingerichtet sein, mindestens zwei Moden eines Moleküls eines innerhalb des Aufnahmeraums der Schwingkreisspule der Haupt-Vorrichtung angeordneten aktiven Mediums zu messen. Die Referenz-Vorrichtung kann eine einzige mitschwingende Mode umfassen.

In einer bevorzugten Ausgestaltung des erfindungsgemäßen Systems
- ist der Kondensator der elektrischen Schwingkreise beider Vorrichtungen jeweils einstellbar,
- ist die aktive elektronische Einrichtung beider Vorrichtungen jeweils als NIC-Schaltung ausgebildet oder umfasst eine solche, wobei die NIC-Schaltung insbesondere eine Operationsverstärkerschaltung und einen elektrisch regelbaren Widerstand aufweist,
- umfassen beide Vorrichtungen jeweils einen parallel zur deren aktiven elektronischen Einrichtung geschalteten Verstärker, der dazu ausgebildet und/oder eingerichtet ist, ein analoges Ausgangszeitsignal an der aktiven elektronischen Einrichtung abzugreifen und zu verstärken, und weisen jeweils einen Analog-Digital-Wandler auf, der dazu ausgebildet und/oder eingerichtet ist, ein von dem Verstärker empfangenes analoges Ausgangszeitsignal in ein digitales Ausgangszeitsignal umzuwandeln,
- ist die Schwingkreisspule der Referenz-Vorrichtung als flache, insbesondere ringförmige, bevorzugt kreisringförmige Spule ausgebildet,
- umfasst die Referenz-Vorrichtung einen Regelkreis für deren aktive elektronische Einrichtung, wobei die Amplitudenmessschaltung des Regelkreises mit dem Verstärker und der Amplitudenstabilisierungsregler des Regelkreises mit dem elektrisch regelbaren Widerstand der Referenz-Vorrichtung verbunden ist,
- umfasst die Haupt-Vorrichtung eine insbesondere als Sattelspule ausgebildete Hochfrequenzanregungsspule, die bevorzugt beide Schwingkreisspulen umgibt, wobei sich die flache Schwingkreisspule der Referenz-Vorrichtung in der Nähe, bevorzugt unterhalb, der Schwingkreisspule der Haupt-Vorrichtung befindet,
- umfasst das in dem von der Schwingkreisspule der Haupt-Vorrichtung umgebenen Aufnahmeraum angeordnete oder anordenbare aktive Medium Moleküle mit X-Kernspins und das in dem von der Schwingkreisspule der Referenz-Vorrichtung umgebenen Aufnahmeraum angeordnete oder anordenbare aktive Medium Atome und/oder Moleküle mit Y-Kernspins,
- weist die Haupt-Vorrichtung eine Pump-Einrichtung auf, die dazu ausgebildet und/oder angeordnet ist, X-Kernspins von Atomen und/oder Molekülen des in dem Aufnahmeraum der Schwingkreisspule der Haupt-Vorrichtung angeordneten oder anordenbaren aktiven Mediums insbesondere mittels eines Hyperpolarisationsverfahrens in einen Zustand negativer oder positiver Kernspinpolarisation zu pumpen, und weist die Referenz-Vorrichtung eine weitere Pump-Einrichtung auf, die dazu ausgebildet und/oder angeordnet ist, Y-Kernspins von Atomen und/oder Molekülen des in dem Aufnahmeraum der Schwingkreisspule der Referenz-Vorrichtung angeordneten oder anordenbaren aktiven Mediums insbesondere mittels eines Hyperpolarisationsverfahrens in einen Zustand negativer Kernspinpolarisation zu pumpen, und
- umfasst das System eine Auswertevorrichtung mit einem NIC-Schaltungs- und Kondensator-Steuerungs-Modul, einem Arbitrary-HF-Puls-Former/Generator-Modul, einem Datenaufnahmemodul, einem Signal-Analyse/FFT-Modul und einem Korrektur-Algorithmen-Modul, wobei die beiden Analog-Digital-Wandler mit zumindest einem Eingang der Auswertevorrichtung und der einstellbare Kondensator und der elektrisch regelbare Widerstand der Haupt-Vorrichtung mit zumindest einem Ausgang der Auswertevorrichtung verbunden sind, und weist das System einen HF-Leistungs-Verstärker auf, der einerseits mit einem Ausgang der Auswertevorrichtung und andererseits mit der Hochfrequenzanregungsspule verbunden ist.

Falls die Schwingkreisspule der Referenz-Vorrichtung als flache, kreisringförmige Spule ausgebildet ist, bedeutet dies, dass sie wie eine Art flacher Hohlzylinder, d.h. ein Hohlzylinder mit einer verglichen zu dessen Radialabmessung relativ kleinen Axialabmessung geformt ist. Die flache Ausbildung der Schwingkreisspule der Referenz-Vorrichtung bietet insbesondere den Vorteil, dass die Schwingkreisspule relativ wenig inhomogenes Feld sieht.

Vorzugsweise ist in dem Aufnahmeraum der Haupt-Vorrichtung ein aktives Medium mit Atomen und/oder Molekülen mit X-Kernspins und in dem Aufnahmeraum der Referenz-Vorrichtung ein aktives Medium mit Atomen und/oder Molekülen mit Y-Kernspins angeordnet, und unterscheiden sich die Kernspinsorten X und Y, wobei insbesondere die Kernspinsorte Y ein gyromagnetisches Verhältnis ungleich der Kernspinsorte X aufweist.

X kann für ein Atom oder Molekül stehen, das aus der Gruppe ausgewählt ist, die aus 1H, ¹³C, ¹⁵N, ²⁹Si, ³¹Ph und ⁵⁷Fe besteht. Y kann für ein Atom oder Molekül stehen, das aus der Gruppe ausgewählt ist, die aus ¹⁹F, ³He und ¹²⁹Xe besteht. Das Atom X und/oder Y kann einen Kernspin von ½ haben. Das aktive Medium der Referenz-Vorrichtung für Y=¹⁹F kann Acetonitril, CF₃-CN, in flüssigem d₅ Methanol unter Anwesenheit eines Ir-Katalysators umfassen.

Bevorzugt handelt es sich bei der Haupt-Vorrichtung um ein X-Kern-RASER/NMR-Spektrometer und/oder bei der Referenz-Vorrichtung um einen Y-Kern-Referenz-RASER.

Beispielsweise können ein ¹⁹F-Referenz-RASER und ein ¹H-RASER/NMR-Spektrometer beide mittels SABRE gepumpt werden. Es ist auch möglich, dass ein ³He-Referenz-RASER mittels SEOP gepumpt wird, und ein ¹H-RASER/NMR-Spektrometer mittels SABRE gepumpt wird. Zweckmäßigerweise umfassen die elektrischen Schaltungen beider Vorrichtungen jeweils eine Ferritspule mit einem Ferritkern, die in Reihe mit der jeweiligen Schwingkreisspule und dem jeweiligen einstellbaren Kondensator geschaltet ist.

Vorteilhafterweise ist die Schwingungsfrequenz und/oder X-Resonanzfrequenz des elektrischen Schwingkreises der Haupt-Vorrichtung insbesondere durch eine entsprechende Dimensionierung des Induktivitätswerts der Schwingkreisspule und/oder der Ferritspule der Haupt-Vorrichtung und eine entsprechende Einstellung des Kapazitätswerts des einstellbaren Kondensators der Haupt-Vorrichtung auf die Larmorfrequenz der X-Kernspins abgestimmt oder abstimmbar. Entsprechend kann die Schwingungsfrequenz und/oder Y-Resonanzfrequenz des elektrischen Schwingkreises der Referenz-Vorrichtung insbesondere durch eine entsprechende Dimensionierung des Induktivitätswerts der Schwingkreisspule und/oder der Ferritspule der Referenz-Vorrichtung und eine entsprechende Einstellung des Kapazitätswerts des einstellbaren Kondensators der Referenz-Vorrichtung auf die Larmorfrequenz der Y-Kernspins abgestimmt oder abstimmbar sein.

Bevorzugt sind die Schwingungsfrequenzen der Schwingkreise der beiden Vorrichtungen derart eingestellt, dass sich von den beiden Vorrichtungen erzeugte Signale nicht oder vernachlässigbar beeinflussen.

Gemäß einer weiteren Ausgestaltung der Erfindung umfasst das System, insbesondere eine der beiden Vorrichtungen, bevorzugt die Haupt-Vorrichtung, einen Magneten, insbesondere geshimmten Elektromagneten, der dazu ausgebildet und/oder eingerichtet ist, ein homogenes, statisches Magnetfeld zu erzeugen. Bevorzugt sind die beiden Schwingkreisspulen, vorzugsweise die beiden Schwingkreisspulen für X- und Y-Kernspins, insbesondere auch die Hochfrequenzanregungsspule, innerhalb dieses Magnetfelds, bevorzugt innerhalb eines homogenen Bereichs dieses Magnetfelds, angeordnet. Bevorzugt ist die sensitive Achse der Hochfrequenzanregungsspule senkrecht zur Richtung des Magnetfelds und sowohl senkrecht zur sensitiven Achse der Schwingkreisspule der Haupt-Vorrichtung als auch senkrecht zur sensitiven Achse der Schwingkreisspule der Referenz-Vorrichtung, orientiert.

Außerdem betrifft die Erfindung ein Verfahren zum Betrieb eines erfindungsgemäßen Systems, bei dem mittels der Haupt-Vorrichtung ein Haupt-Messsignal, insbesondere Haupt-Ausgangszeitsignal, zur Bestimmung der Struktur von Molekülen mit X-Kernspins eines aktiven Mediums, das diese Moleküle umfasst oder daraus besteht und das in dem Aufnahmeraum der Haupt-Vorrichtung angeordnet ist oder wird, bereitgestellt wird, aus dem insbesondere ein Haupt-Frequenzspektrum ableitbar ist, und mittels der Referenz-Vorrichtung ein Referenz-Messsignal, insbesondere Referenz-Ausgangszeitsignal, aus dem insbesondere ein Referenz-Frequenzspektrum ableitbar ist, als Referenz zum Korrigieren von durch Magnetfeldschwankungen und/oder sonstigen Umgebungsbedingungen bedingten Störungen in dem Haupt-Messsignal bereitgestellt wird, wobei die Referenz-Vorrichtung mit einem aktiven Medium mit Atomen und/oder Molekülen mit Y-Kernspins, das in dem Aufnahmeraum der Referenz-Vorrichtung angeordnet ist oder wird, betrieben wird, und sich die X- und Y-Kernspins unterscheiden, insbesondere ein unterschiedliches gyromagnetisches Verhältnis aufweisen.

Bevorzugt wird mittels der Referenz-Vorrichtung ein amplitudenstabilisiertes Referenz-Messsignal bereitgestellt.

Vorzugsweise dient mindestens eine Referenzfrequenz von Y als hochgenauer Magnetsensor und zur Korrektur von Magnetfeldschwankungen eines aus dem Haupt-Messsignal der Haupt-Vorrichtung abgeleiteten Haupt-Frequenzspektrums, wodurch eine hauptsächlich durch Magnetfeldfluktuationen verursachte Limitierung der Frequenzauflösung der Haupt-Vorrichtung vollständig aufgehoben werden kann. Jede Einzelmessung der Haupt-Vorrichtung mit seinen spezifischen Feldschwankungen kann mithilfe der Referenz korrigiert werden. Somit können alle Einzelmessungen ohne Phasenverlust superponiert (gemittelt) oder untereinander verglichen werden. Diese Maßnahme ersetzt also die extrem hohe zeitliche Magnetfeldstabilität, welche u.a. einen Hochfeld-Supraleiter auszeichnet. Bevorzugt handelt es sich bei der Referenz-Vorrichtung um eine Y-Referenz-RASER-Vorrichtung, die vorzugsweise von der Haupt-Vorrichtung, bei der mehrere Moden RASER-aktiv sein können, völlig unabhängig ist. Anstatt von "RASER-aktiven Moden" kann man auch von NMR-Linien sprechen. Auf diese Weise lassen sich nicht nur beliebig komplizierte Haupt-Frequenzspektren, insbesondere Haupt-RASER-Spektren, von Magnetfeldfluktuationen befreien beziehungsweise korrigieren, sondern die Korrektur gelingt auch bei zeitlich nacheinander erfolgten und unkorrelierten Messungen, insbesondere RASER-Messungen, der Haupt-Vorrichtung je für eine einzelne Mode, aus denen mithilfe der Referenz das Gesamtspektrum rekonstruiert werden kann. Die Y-Referenz-RASER-Vorrichtung kann für sich allein ein neuartiger Magnetfeldsensor sein, der eine Alternative zu existierenden optisch gepumpten (³He, ¹²⁹Xe, Kalium-SERF) oder zu SQUID-Magnetometern darstellt. Ein Vorteil z.B. eines SABRE-gepumpten ¹⁹F-RASER-Magnetometers ist, dass ein Betrieb der Probe bei 300 K möglich ist (bei Erzeugung von p-H₂-Gas bei moderaten 150 K), während rauscharme SQUIDs bei 4 K und ³He oder K-SERF-Atommagnetometer bei ca. 480 K operieren.

Zweckmäßigerweise wird bei dem Verfahren ein erfindungsgemäßes System bereitgestellt und mittels der Referenz-Vorrichtung des Systems ein Referenz-Ausgangszeitsignal als Referenz bereitgestellt, indem
- das aktive Medium der Referenz-Vorrichtung einem homogenen, statischen Magnetfeld ausgesetzt wird, wodurch zumindest ein Teil der Y-Kernspins in Richtung des homogenen, statischen Magnetfelds ausgerichtet wird, wobei das bereitgestellte System insbesondere einen Magneten umfasst, der das homogene, statische Magnetfeld erzeugt;
- Y-Kernspins des aktiven Mediums der Referenz-Vorrichtung mittels der Pump-Einrichtung der Referenz-Vorrichtung, insbesondere mittels eines mit Hilfe der Pump-Einrichtung der Referenz-Vorrichtung durchgeführten Hyperpolarisationsverfahrens, in einen Zustand negativer Kernspinpolarisation gepumpt werden;
- insbesondere das aktive Medium der Referenz-Vorrichtung insbesondere spontan und/oder stimuliert elektromagnetische Strahlung emittiert, die in der Schwingkreisspule der Referenz-Vorrichtung eine oszillierende Spannung, insbesondere mit konstanter Amplitude, induziert;
- der elektrische Schwingkreis der Referenz-Vorrichtung, der insbesondere die Schwingkreisspule, den einstellbaren Kondensator und die Ferritspule der Referenz-Vorrichtung umfasst, mittels der aktiven elektronischen Einrichtung der Referenz-Vorrichtung aktiv entdämpft wird, wodurch die RASER-Schwelle, ab der der elektrische Schwingkreis der Referenz-Vorrichtung, insbesondere die Anordnung aus dem elektrischen Schwingkreis und dem aktiven Medium der Referenz-Vorrichtung, zu schwingen beginnt, herabgesetzt wird;
- beim Überschreiten der RASER-Schwelle eine insbesondere kontinuierliche RASER-Schwingung bei der Y-Resonanzfrequenz in dem elektrischen Schwingkreis der Referenz-Vorrichtung entsteht;
- insbesondere die Amplitude der RASER-Schwingung durch eine aktive Regelung mittels des Regelkreises stabil auf einem vorgegebenen Wert gehalten wird, wobei hierbei mittels des Regelkreises der elektrisch regelbare Widerstand der Referenz-Vorrichtung und hierüber insbesondere die Güte des elektrischen Schwingkreises der Referenz-Vorrichtung geregelt wird; und
- der Verstärker der Referenz-Vorrichtung ein analoges Referenz-Ausgangszeitsignal, insbesondere analoges RASER-Schwingungs-Referenz-Ausgangszeitsignal, an der aktiven elektronischen Einrichtung der Referenz-Vorrichtung abgreift und verstärkt und das verstärkte analoge Referenz-Ausgangszeitsignal an den Analog-Digital-Wandler der Referenz-Vorrichtung weiterleitet, der das amplitudenstabilisierte, analoge Referenz-Ausgangszeitsignal in ein digitales Referenz-Ausgangszeitsignal umwandelt und das digitale Referenz-Ausgangszeitsignal als Referenz an die Auswertevorrichtung, insbesondere deren Datenaufnahme-Modul, weiterleitet.

Bei dem Verfahren kann ein erfindungsgemäßes System bereitgestellt werden und mittels der Haupt-Vorrichtung und der Auswertevorrichtung des Systems mit einer einzelnen Messung oder mehreren Messungen ein X-NMR-Spektrum der Moleküle mit X-Kernspins als Haupt-Frequenzspektrum bereitgestellt werden, um die ungefähre Linienposition und/oder Amplitude zumindest der größten X-Resonanz/Linie, insbesondere aller X-Resonanzen/Linien, zu erfassen, indem
- das aktive Medium der Haupt-Vorrichtung einem homogenen, statischen Magnetfeld ausgesetzt wird, wodurch zumindest ein Teil der X-Kernspins in Richtung des homogenen, statischen Magnetfelds ausgerichtet wird, wobei insbesondere das aktive Medium der Haupt-Vorrichtung und das aktive Medium der Referenz-Vorrichtung dem gleichen Magnetfeld ausgesetzt werden und/oder das bereitgestellte System insbesondere einen Magneten umfasst, der das homogene, statische Magnetfeld erzeugt;
- insbesondere X-Kernspins des aktiven Mediums der Haupt-Vorrichtung mittels der Pump-Einrichtung der Haupt-Vorrichtung, insbesondere mittels eines mit Hilfe der Pump-Einrichtung der Haupt-Vorrichtung durchgeführten Hyperpolarisationsverfahrens, beispielsweise DNP, SABRE, PHIP oder SEOP, in einen Zustand negativer oder positiver Kernspinpolarisation gepumpt werden;
- der elektrische Schwingkreis der Haupt-Vorrichtung, der insbesondere die Schwingkreisspule, den einstellbaren Kondensator und die Ferritspule der Haupt-Vorrichtung umfasst, mittels der aktiven elektronischen Einrichtung der Haupt-Vorrichtung aktiv entdämpft wird;
- mit der NIC-Schaltung der Haupt-Vorrichtung, insbesondere durch Einstellung des Widerstandswerts des elektrisch regelbaren Widerstands über die Auswertevorrichtung, bevorzugt über deren NIC-Schaltungs- und Kondensator-Steuerungs-Modul, im Falle einer negativen Kernspinpolarisation der X-Kernspins die Güte der Haupt-Vorrichtung, insbesondere des elektrischen Schwingkreises der Haupt-Vorrichtung, unterhalb einer RASER-Schwelle, insbesondere der RASER-Schwelle für eine verglichen mit einer weiteren Linie großen Linie, insbesondere auf einen Wert unter 100, beispielsweise auf einen Wert von 40, eingestellt wird, oder mit der NIC-Schaltung der Haupt-Vorrichtung, insbesondere durch Einstellung des Widerstandswerts des elektrisch regelbaren Widerstands über die Auswertevorrichtung, bevorzugt über deren NIC-Schaltungs- und Kondensator-Steuerungs-Modul, im Falle einer positiven Kernspinpolarisation der X-Kernspins die Güte der Haupt-Vorrichtung, insbesondere des elektrischen Schwingkreises der Haupt-Vorrichtung, so hoch eingestellt wird, dass der elektrische Schwingkreis der Haupt-Vorrichtung nicht, bevorzugt gerade nicht, anfängt mit seiner Eigenfrequenz zu schwingen, insbesondere auf einen Wert von mindestens 10⁵ eingestellt wird, wobei insbesondere der eingestellte Wert der Güte ein Vielfaches eines Werts der niedrigsten RASER-Schwelle einer häufig vorkommenden Spin-Spezies beträgt, insbesondere um einen Faktor Eintausend größer ist als die niedrigste RASER-Schwelle einer häufig vorkommenden Spin-Spezies;
- durch einen Hochfrequenz-Anregungspuls, vorzugsweise 90°-Hochfrequenz-Anregungspuls, der insbesondere eine gaußförmige oder rechteckige Einhüllende umfasst, mit der Hochfrequenzanregungsspule ein freier Induktionszerfall von Molekülen des aktiven Mediums der Haupt-Vorrichtung erhalten wird, wobei insbesondere der Hochfrequenz-Anregungspuls von dem Arbitrary-HF-Puls-Former/Generator-Modul der Auswertevorrichtung erzeugt wird;
- der zeitliche Verlauf des freien Induktionszerfalls von der Schwingkreisspule der Haupt-Vorrichtung erfasst wird;
- der Verstärker der Haupt-Vorrichtung ein zu dem freien Induktionszerfall korrespondierendes analoges Haupt-Ausgangszeitsignal an der aktiven elektronischen Einrichtung der Haupt-Vorrichtung abgreift und verstärkt und das verstärkte analoge Haupt-Ausgangszeitsignal an den Analog-Digital-Wandler der Haupt-Vorrichtung weiterleitet, der das analoge Haupt-Ausgangszeitsignal in ein digitales Haupt-Ausgangszeitsignal umwandelt und das digitale Haupt-Ausgangszeitsignal an die Auswertevorrichtung weiterleitet; und
- das digitale Haupt-Ausgangszeitsignal mittels des Signal-Analyse/FFT-Moduls der Auswertevorrichtung fouriertransformiert wird, um ein X-NMR-Spektrum zu erhalten.

Bei der zumindest einen weiteren Linie handelt es sich verglichen mit der großen Linie um eine kleine Linie. Der Ausdruck "gerade nicht anfängt mit seiner Eigenfrequenz zu schwingen" bedeutet, dass die Güte auf einen Wert eingestellt wird, der möglichst hoch ist, gleichzeitig jedoch noch unterhalb eines Wertes liegt, bei dem der elektrische Schwingkreis anfängt mit seiner Eigenfrequenz zu schwingen. Ausdrücke wie "häufig vorkommende Spin-Spezies" oder "selten vorkommende Spin-Spezies" in dieser Anmeldung beziehen sich insbesondere auf die natürliche Häufigkeit. Grundsätzlich ist es auch möglich, zumindest zunächst auf das Pumpen von X-Kernspins des aktiven Mediums der Haupt-Vorrichtung, insbesondere des X-RASER/NMR-Spektrometers, zu verzichten. Dann kann das X-RASER/NMR-Spektrometer als NMR-Spektrometer genutzt werden, wobei SNR ∼ Q^{1/2} Pₜₕ (Pₜₕ = thermische Protonen-Boltzmannpolarisation ∼ 10⁻⁶ bei 1T und 300 K). Falls X-Kernspins des aktiven Mediums der Haupt-Vorrichtung insbesondere mittels eines Hyperpolarisationsverfahrens in einen Zustand positiver Kernspinpolarisation gepumpt werden, d.h. Px >> Pₜₕ > 0, findet keine RASER-Aktivität der Haupt-Vorrichtung, insbesondere des X-RASER/NMR-Spektrometers, statt. Es kann jedoch ein NMR-Spektrum mit erhöhtem SNR ∼ Q^{1/2} P_{X} gemessen werden.

Falls das aktive Medium der Haupt-Vorrichtung und das aktive Medium der Referenz-Vorrichtung dem gleichen Magnetfeld ausgesetzt werden, beeinflussen Schwankungen dieses Magnetfelds beide aktiven Medien gleichermaßen, wodurch ein an dem elektrischen Schwingkreis der Referenz-Vorrichtung abgegriffenes Ausgangszeitsignal als Referenz für die Haupt-Vorrichtung dienen kann.

Bei dem Verfahren kann ein erfindungsgemäßes System bereitgestellt werden und mittels der Haupt-Vorrichtung und der Auswertevorrichtung des Systems ein X-RASER-Spektrum der Moleküle mit X-Kernspins als Haupt-Frequenzspektrum bereitgestellt werden, indem
- X-Kernspins des aktiven Mediums der Haupt-Vorrichtung mittels der Pump-Einrichtung der Haupt-Vorrichtung, insbesondere mittels eines mit Hilfe der Pump-Einrichtung der Haupt-Vorrichtung durchgeführten Hyperpolarisationsverfahrens, in einen Zustand negativer Kernspinpolarisation gepumpt werden;
- der elektrische Schwingkreis der Haupt-Vorrichtung, der insbesondere die Schwingkreisspule, den einstellbaren Kondensator und die Ferritspule der Haupt-Vorrichtung umfasst, mittels der aktiven elektronischen Einrichtung der Haupt-Vorrichtung aktiv entdämpft wird;
- eine RASER-Aktivität einer verglichen mit zumindest einer weiteren Linie großen Linie erzwungen wird, wobei insbesondere die weitere Linie verglichen mit der großen Linie eine um den Faktor Eintausend kleinere Amplitude aufweist, indem
- der elektrische Schwingkreis der Haupt-Vorrichtung insbesondere mittels eines Einstellens des einstellbaren Kondensators der Haupt-Vorrichtung auf das Maximum der großen Linie eingestimmt wird, und
- mit der NIC-Schaltung der Haupt-Vorrichtung, insbesondere durch Einstellung des Widerstandswerts des elektrisch regelbaren Widerstands über die Auswertevorrichtung, bevorzugt über deren NIC-Schaltungs- und Kondensator-Steuerungs-Modul, die Güte der Haupt-Vorrichtung, insbesondere des elektrischen Schwingkreises der Haupt-Vorrichtung, soweit erhöht wird, bis die RASER-Aktivität der großen Linie einsetzt, oder die Güte auf oder oberhalb der RASER-Schwelle für die große Linie eingestellt wird, so dass die RASER-Aktivität der großen Linie einsetzt;
- der Verstärker der Haupt-Vorrichtung insbesondere nach einem Einschwingen der RASER-Schwingung in ein stationäres Gleichgewicht ein analoges X-RASER-Haupt-Ausgangszeitsignal an der aktiven elektronischen Einrichtung der Haupt-Vorrichtung abgreift und verstärkt und das verstärkte analoge X-RASER-Haupt-Ausgangszeitsignal an den Analog-Digital-Wandler der Haupt-Vorrichtung weiterleitet, der das analoge X-RASER-Haupt-Ausgangszeitsignal in ein digitales X-RASER-Haupt-Ausgangszeitsignal umwandelt und das digitale X-RASER-Haupt-Ausgangszeitsignal an die Auswertevorrichtung weiterleitet, wobei das X-RASER-Haupt-Ausgangszeitsignal insbesondere mit einer beliebig langen Messzeit aufgenommen wird;
- das digitale X-RASER-Haupt-Ausgangszeitsignal mittels des Signal-Analyse/FFT-Moduls der Auswertevorrichtung fouriertransformiert wird, um ein X-RASER-Spektrum zu erhalten, wobei das X-RASER-Spektrum, insbesondere dessen große Linie, durch Magnetfeldschwankungen verbreitert ist.

Wenn also X-Kernspins des aktiven Mediums der Haupt-Vorrichtung insbesondere mittels eines Hyperpolarisationsverfahrens in einen Zustand negativer Kernspinpolarisation gepumpt werden, und P_{X} < 0 sowie |P_{X}| > |P_{S}| (P_{S} = Kernspinpolarisation an der RASER-Schwelle) gilt, dann ergeben sich RASER-Oszillationen.

Gemäß einer bevorzugten Ausgestaltung der Erfindung wird bei dem Verfahren
- mittels des Korrektur-Algorithmen-Moduls der Auswertevorrichtung unter Zuhilfenahme des an der Referenz-Vorrichtung erfassten und von deren Analog-Digital-Wandler an die Auswertevorrichtung weitergeleiteten Referenz-Ausgangszeitsignals und/oder eines mittels Fourieranalyse daraus erhaltenen Y-RASER-Referenzspektrums, welches insbesondere durch die gleichen Magnetfeldschwankungen wie das X-RASER-Spektrum verbreitert ist, das X-RASER-Spektrum von durch die Magnetfeldschwankungen bedingten Störungen korrigiert und insbesondere ein verglichen mit dem unkorrigierten X-RASER-Spektrum schmaleres korrigiertes X-RASER-Spektrum erhalten.

Bei dem Verfahren kann mittels der Haupt-Vorrichtung und der Auswertevorrichtung ein weiteres X-RASER-Spektrum der Moleküle mit X-Kernspins als Haupt-Frequenzspektrum bereitgestellt werden, indem
- eine RASER-Aktivität der zumindest einen weiteren Linie erzwungen wird, indem
- der elektrische Schwingkreis der Haupt-Vorrichtung insbesondere durch eine Veränderung des Werts des einstellbaren Kondensators der Haupt-Vorrichtung verstimmt wird, wobei der elektrische Schwingkreis der Haupt-Vorrichtung auf eine Frequenz eingestimmt wird, die höher oder niedriger als die Resonanzfrequenz der großen Linie ist,
- mit der NIC-Schaltung der Haupt-Vorrichtung, insbesondere durch Einstellung des Widerstandswerts des elektrisch regelbaren Widerstands über die Auswertevorrichtung, bevorzugt über deren NIC-Schaltungs- und Kondensator-Steuerungs-Modul, die Güte der Haupt-Vorrichtung, insbesondere des elektrischen Schwingkreises der Haupt-Vorrichtung, schrittweise, insbesondere auf einen Wert von mindestens 10⁵, bevorzugt mindestens 10⁶, besonders bevorzugt mindestens 10⁷ erhöht wird, wodurch insbesondere die RASER-Schwelle der zumindest einen weiteren Linie überschritten wird, und
- die Resonanzfrequenz in vorgegebenen Frequenzintervallen, beispielsweise für Q = 10⁷ in Intervallen von 0,1 Hz, schrittweise über einen vorgegebenen Frequenzbereich in der Nähe der großen Linie verstimmt wird, insbesondere indem der Wert des einstellbaren Kondensators der Haupt-Vorrichtung variiert wird, und wenn die Resonanzfrequenz der zumindest einen weiteren Linie erreicht wird, die RASER-Aktivität der zumindest einen weiteren Linie einsetzt;
- der Verstärker der Haupt-Vorrichtung insbesondere nach einem Einschwingen der RASER-Schwingung in ein stationäres Gleichgewicht ein analoges X-RASER-Haupt-Ausgangszeitsignal an der aktiven elektronischen Einrichtung der Haupt-Vorrichtung abgreift und verstärkt und das verstärkte analoge X-RASER-Haupt-Ausgangszeitsignal an den Analog-Digital-Wandler der Haupt-Vorrichtung weiterleitet, der das analoge X-RASER-Haupt-Ausgangszeitsignal in ein digitales X-RASER-Haupt-Ausgangszeitsignal umwandelt und das digitale X-RASER-Ausgangszeitsignal an die Auswertevorrichtung weiterleitet, wobei das X-RASER-Haupt-Ausgangszeitsignal insbesondere mit einer beliebig langen Messzeit aufgenommen wird; und
- das X-RASER-Haupt-Ausgangszeitsignal mittels des Signal-Analyse/FFT-Moduls der Auswertevorrichtung fouriertransformiert wird, um ein weiteres X-RASER-Spektrum zu erhalten, wobei insbesondere das weitere X-RASER-Spektrum die große Linie und die zumindest eine weitere Linie als zumindest zwei koexistierende Linien umfasst, und die große Linie und die zumindest eine weitere Linie durch insbesondere dieselben Magnetfeldschwankungen verbreitert sind, wobei die verbreiterten Strukturen der großen Linie und der zumindest einen weiteren Linie bevorzugt selbstähnlich sind und/oder die RASER-Aktivität der zumindest einen weiteren Linie wenig oder gar nicht durch die große Linie unterdrückt wird und/oder die verbreiterten Strukturen der großen Linie und der zumindest einen weiteren Linie überlappen.

Bei den zuvor erwähnten Verfahrensschritten wird also sowohl die Güte schrittweise erhöht als auch die Resonanzfrequenz schrittweise verstimmt, beispielsweise schrittweise erhöht oder schrittweise erniedrigt. Es werden also sowohl die Güte als auch die Resonanzfrequenz variiert. Beispielsweise kann bei jeder eingestellten Frequenz die Güte so weit wie möglich erhöht werden oder kann bei jeder eingestellten Güte die Frequenz insbesondere innerhalb des vorgegebenen Frequenzbereichs variiert werden. Die Güte der Haupt-Vorrichtung, insbesondere des elektrischen Schwingkreises der Haupt-Vorrichtung, kann so knapp wie möglich unter die Selbsterregung des elektrischen Schwingkreises erhöht werden. Insbesondere für eine Frequenz im 1 MHz-Bereich ist eine Erhöhung der Güte auf einen Wert im Bereich von 10⁵ - 10⁸ denkbar. Bezeichnet man das Frequenzintervall als Δf, so gilt für Q = 107 und mit der großen Linie bei der Frequenz vo: Δf = v₀Q = 10⁶ Hz/10⁷ = 0,1 Hz. Grundsätzlich ist es auch möglich, lediglich die Frequenz zu variieren, wobei in diesem Fall die Güte auf einen bestimmten, bevorzugt möglichst hohen Wert eingestellt wird.

Verglichen mit Standard-NMR-Spektrometern ergibt sich ein erhöhtes SNR und eine größere Genauigkeit bei der Bestimmung von Linienmaxima, wobei die Grenze der Genauigkeit durch Magnetfeldfluktuationen des Magnetfelds B₀ und der Umgebung limitiert ist.

Vorzugsweise wird bei dem Verfahren
- mittels des Korrektur-Algorithmen-Moduls der Auswertevorrichtung unter Zuhilfenahme des an der Referenz-Vorrichtung erfassten und von deren Analog-Digital-Wandler an die Auswertevorrichtung weitergeleiteten Referenz-Ausgangszeitsignals und/oder eines mittels Fourieranalyse daraus erhaltenen Y-RASER-Referenzspektrums, welches insbesondere durch die gleichen Magnetfeldschwankungen wie das weitere X-RASER-Spektrum verbreitert ist, das weitere X-RASER-Spektrum von durch die Magnetfeldschwankungen bedingten Störungen korrigiert und insbesondere ein verglichen mit dem unkorrigierten weiteren X-RASER-Spektrum schmaleres korrigiertes weiteres X-RASER-Spektrum erhalten, welches insbesondere jeweils eine schmale Linie für die große Linie und die zumindest eine weitere Linie aufweist, wobei bevorzugt die Frequenzdifferenz der beiden schmalen Linien der chemischen Verschiebungsdifferenz der beiden Linien entspricht.

Somit ermöglicht das erfindungsgemäße Verfahren, dass auch Linien mit relativ kleiner Amplitude selektiv RASER-aktiv sein können, wobei die RASER-Aktivität der kleineren Linie wenig oder gar nicht durch die große Linie unterdrückt wird. Das Prinzip des "Überlebens der stärksten Mode" ("survival of the fittest") für einen standardmäßigen breitbandigen RASER-Resonator wird durch die extrem hohe Güte und der damit verbundenen extrem kleinen Bandbreite des RASER-Resonators umgewandelt in eine "erzwungene selektive Anregung der schwächsten Moden" ("forced selective survival of the weakest").

Optional können nichtlineare Frequenzverschiebungen, die bei Koexistenz von zwei oder mehr Linien auftreten, aus mehreren Messungen bei verschiedenen Resonanzfrequenzen eliminiert werden.

Eine weitere Ausgestaltung der Erfindung zeichnet sich dadurch aus, dass für den Fall, dass die große Linie und die zumindest eine weitere Linie nicht koexistieren, die Position jeder Linie für sich alleine in zumindest zwei getrennten X-RASER-Messungen mit unterschiedlich eingestellter Güte bestimmt wird, und insbesondere die absolute Frequenzdifferenz der beiden Linien mithilfe der von der Referenz-Vorrichtung bereitgestellten Referenz bestimmt wird, wobei insbesondere die zwischen den zeitlich versetzten X-RASER-Messungen stattgefundenen Magnetfeldschwankungen mit der von der Referenz-Vorrichtung bereitgestellten Referenz bestimmt und aus den sich ergebenden X-RASER-Spektren eliminiert werden.

Das Model mit einer großen Linie und einer weiteren Linie, die verglichen mit der großen Linie klein und verschoben ist, steht auch repräsentativ für ¹H-(¹³C, ¹⁵N, ²⁹Si, ³¹Ph, ⁵⁷Fe, etc..) J-gekoppelte NMR-Spektren im Hochfeld, für chemische Verschiebungsdifferenzen (wenn mindestens zwei ¹H-Spins mit unterschiedlichen chemischen Verschiebungen RASER-aktiv sind) und schließlich auch für den allgemeineren Fall wo mindestens zwei RASER-aktive ¹H-Gruppen (z.B. ein Ringproton und eine CH₃ Gruppe) miteinander homo-nuklear J-gekoppelt sind.

Die Schwingungsfrequenz und/oder Y-Resonanzfrequenz des elektrischen Schwingkreises der Referenz-Vorrichtung kann durch entsprechendes Einstellen des Kapazitätswerts des einstellbaren Kondensators der Referenz-Vorrichtung auf die Larmorfrequenz der Y-Kernspins, insbesondere der ¹⁹F-Kernspins oder ³He-Kernspins, abgestimmt werden. Ebenso kann die Schwingungsfrequenz und/oder X-Resonanzfrequenz des elektrischen Schwingkreises der Haupt-Vorrichtung durch Einstellen des Kapazitätswerts des einstellbaren Kondensators der Haupt-Vorrichtung eingestellt werden. Der Kapazitätswert des einstellbaren Kondensators der Referenz-Vorrichtung und/oder des einstellbaren Kondensators der Haupt-Vorrichtung wird insbesondere über die Auswertevorrichtung, bevorzugt deren NIC-Schaltungs- und Kondensator-Steuerungs-Modul, eingestellt.

Eine weitere Ausgestaltung der Erfindung zeichnet sich dadurch aus, dass
- in dem von der Schwingkreisspule der Haupt-Vorrichtung umgebenen Aufnahmeraum ein aktives Medium, welches Moleküle mit häufigen X-Kernen, wie etwa ¹H-Kernen, mit X-Kernspins und seltenen X-Kernen, wie etwa ¹³C-, ¹⁵N-, ²⁹Si-, ³¹Ph- und/oder ⁵⁷Fe-Kernen, mit X-Kernspins umfasst, angeordnet und insbesondere einem homogenen, statischen Magnetfeld ausgesetzt wird, wodurch zumindest ein Teil der X-Kernspins in Richtung des homogenen, statischen Magnetfelds ausgerichtet wird;
- X-Kernspins des aktiven Mediums der Haupt-Vorrichtung mittels der Pump-Einrichtung der Haupt-Vorrichtung in einen Zustand negativer Kernspinpolarisation gepumpt werden;
- eine RASER-Aktivität mindestens eines häufigen X-Kerns erzwungen wird, indem mit der NIC-Schaltung der Haupt-Vorrichtung, insbesondere durch Einstellung des Widerstandswerts des elektrisch regelbaren Widerstands der NIC-Schaltung der Haupt-Vorrichtung, die Güte der Haupt-Vorrichtung, insbesondere des elektrischen Schwingkreises der Haupt-Vorrichtung, soweit erhöht wird, bis die RASER-Aktivität des häufigen X-Kerns einsetzt, wobei sich neben dem mindestens einen sich in einem RASER-aktiven Zustand befindlichen häufigen X-Kern häufige und/oder seltene X-Kerne in einem RASER-inaktiven Zustand befinden; und
- wenigstens eine, bevorzugt alle RASER-aktiven Resonanzen/Linien, welche homo- und hetero-nukleare J-Kopplungen zwischen dem mindestens einen RASER-aktiven häufigen X-Kern und den RASER-inaktiven häufigen und/oder RASER-inaktiven seltenen X-Kernen widerspiegeln, durch einen insbesondere schrittweisen Scan mit vorgegebenen Frequenzintervallen in einem vorgegebenen Frequenzbereich nahe der Resonanzfrequenz des häufigen X-Kerns, wobei die Frequenz insbesondere durch Veränderung des Wertes des einstellbaren Kondensators der Haupt-Vorrichtung variiert wird, gemessen werden, um die Struktur der Moleküle zu bestimmen. Bei jeder eingestellten Frequenz kann die Güte der Haupt-Vorrichtung, bevorzugt des elektrischen Schwingkreises der Haupt-Vorrichtung, mit der NIC-Schaltung der Haupt-Vorrichtung, insbesondere durch Einstellung des Widerstandswerts des elektrisch regelbaren Widerstands der NIC-Schaltung der Haupt-Vorrichtung, variiert, insbesondere schrittweise erhöht werden.

Auch in diesem Fall kann an der elektrischen Schaltung der Haupt-Vorrichtung, insbesondere an der NIC-Schaltung der Haupt-Vorrichtung, ein X-RASER-Ausgangszeitsignal abgegriffen und daraus insbesondere mittels einer Fouriertransformation ein entsprechendes X-RASER-Spektrum erhalten werden. Das X-RASER-Spektrum kann mittels des Korrektur-Algorithmen-Moduls der Auswertevorrichtung des Systems unter Zuhilfenahme eines an der Referenz-Vorrichtung erfassten und von dieser an die Auswertevorrichtung weitergeleiteten Referenz-Ausgangszeitsignals und/oder eines mittels Fourieranalyse daraus erhaltenen Y-RASER-Referenzspektrums, welches insbesondere durch die gleichen Magnetfeldschwankungen wie das X-RASER-Spektrum verbreitert ist, von durch die Magnetfeldschwankungen bedingten Störungen korrigiert werden.

Die Auswertevorrichtung kann die von der Haupt-Vorrichtung und der Referenz-Vorrichtung erhaltenen insbesondere digitalen Ausgangszeitsignale weiterverarbeiten, wie etwa fouriertransformieren, und/oder analysieren beziehungsweise auswerten.

Zweckmäßigerweise wird bei den zuvor erwähnten Einstellungen der Güte insbesondere des elektrischen Schwingkreises der Haupt-Vorrichtung, diese derart eingestellt, dass der entsprechende elektrische Schwingkreis, insbesondere die Anordnung aus dem elektrischen Schwingkreis und dem jeweiligen aktiven Medium, nicht von alleine schwingt.

Für die zuvor beschriebenen erfindungsgemäßen Verfahren gilt, dass die Verfahrensschritte bevorzugt in der zuvor aufgeführten Reihenfolge ausgeführt werden. Jedoch versteht es sich, dass die Verfahrensschritte grundsätzlich auch in einer beliebigen anderen Reihenfolge ausführbar sind. Darüber hinaus sind die im Zusammenhang mit den einzelnen erfindungsgemäßen Verfahren beschriebenen Verfahrensschritte nicht auf das jeweilige Verfahren beschränkt, d.h. einzelne im Zusammengang mit einem bestimmten Verfahren beschriebene Verfahrensschritte können auch in einem der anderen erfindungsgemäßen Verfahren durchgeführt werden. Auch können einzelne Verfahrensschritte weggelassen oder durch andere Verfahrensschritte ersetzt werden.

In der vorliegenden Beschreibung sind die Begriffe "Mode" und "NMR- und/oder RASER-Linie", kurz "Linie", gleichbedeutend.

Weitere Merkmale und Vorteile der vorliegenden Erfindung werden anhand der nachfolgenden Beschreibung einer Ausführungsform eines erfindungsgemäßen Systems unter Bezugnahme auf die beiliegende Zeichnung deutlich. Darin zeigt:
- Figur 1: ein erfindungsgemäßes System gemäß einer Ausführungsform der vorliegenden Erfindung,
- Figur 2: eine separate Ansicht der Haupt-Vorrichtung des Systems aus Figur 1,
- Figur 3: eine detaillierte Ansicht der aktiven elektronischen Einrichtung der Haupt-Vorrichtung und der Referenz-Vorrichtung des Systems aus Figur 1,
- Figur 4: eine detaillierte Ansicht einer alternativ ausgestalteten aktiven elektronischen Einrichtung der Haupt-Vorrichtung und der Referenz-Vorrichtung,
- Figur 5: eine zur Veranschaulichung dienende schematische vergrößerte Ansicht von Komponenten der Referenz-Vorrichtung des Systems aus Figur 1 mit eingezeichneten elektrischen Leitwerten,
- Figur 6: eine Strukturformel eines Moleküls des aktiven Mediums der Haupt-Vorrichtung des Systems aus Figur 1,
- Figur 7: einen Zeitverlauf eines simulierten ¹H-FID inklusive 10 % Rauschanteil des Moleküls aus Figur 6 nach einer 90 ° -Puls-Anregung,
- Figur 8: ein ¹H-Spektrum nach einer Fouriertransformation des Zeitverlaufs aus Figur 7,
- Figur 9: ein ¹H-RASER-Spektrum mit Magnetfeldschwankungen in Form eines schematischen Balkenspektrums,
- Figur 10: das mit einer ¹⁹F-Referenz korrigierte ¹H-RASER-Spektrum aus Figur 9,
- Figur 11: ein weiteres ¹H-RASER-Spektrum mit Magnetfeldschwankungen in Form eines schematischen Balkenspektrums, und
- Figur 12: das mit einer ¹⁹F-Referenz korrigierte ¹H-RASER-Spektrum aus Figur 11.

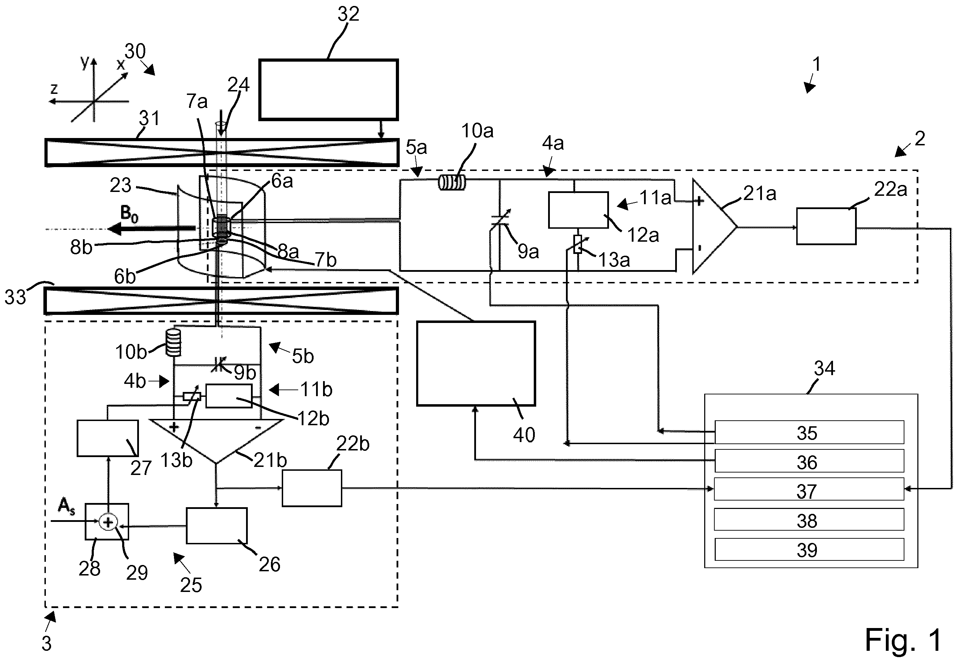

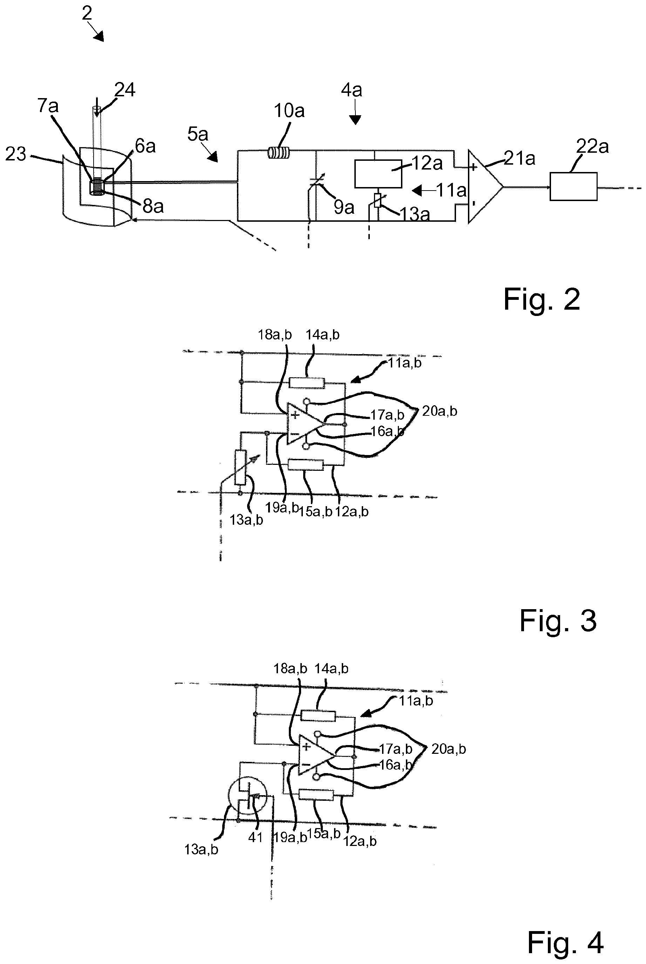

Figur 1 zeigt ein System 1 zur hochpräzisen Bestimmung der Struktur eines zu untersuchenden Moleküls gemäß einer Ausführungsform der vorliegenden Erfindung. Das System 1 umfasst eine in Figur 2 separat dargestellte Haupt-Vorrichtung 2 und eine Referenz-Vorrichtung 3.

Die Haupt-Vorrichtung 2 umfasst eine elektrische Schaltung 4a, die einen elektrischen Schwingkreis 5a, nämlich einen Parallelschwingkreis, aufweist. Der elektrische Schwingkreis 5a umfasst eine zylinderförmige Schwingkreisspule 6a, die einen Aufnahmeraum 7a, in dem ein aktives Medium 8a während des Betriebs der Haupt-Vorrichtung 2 angeordnet ist, um mit der Schwingkreisspule 6a über Faradayinduktion wechselzuwirken, umgibt und die eine Induktivität L₁ aufweist. Außerdem umfasst der elektrische Schwingkreis 5a einen einstellbaren Kondensator 9a. Darüber hinaus weist die elektrische Schaltung 4a eine Ferritspule 10a auf, die mit der Schwingkreisspule 6a und dem Kondensator 9a in Reihe geschaltet ist. Außerdem weist die elektrische Schaltung 4a eine als NIC-Schaltung 11a ausgebildete, aktive elektronische Einrichtung auf, die zur aktiven Entdämpfung des elektrischen Schwingkreises 5a ausgebildet ist. Die NIC-Schaltung 11a ist parallel zu dem Kondensator 9a geschaltet und derart ausgebildet, dass die Stärke der von ihr bewirkten Entdämpfung einstellbar ist. Konkret umfasst die NIC-Schaltung 11a eine Operationsverstärkerschaltung 12a und einen elektrisch regelbaren Widerstand 13a, der mit der Operationsverstärkerschaltung 12a in Reihe geschaltet ist. Der detaillierte Aufbau der Operationsverstärkerschaltung 12a der NIC-Schaltung 11a ist in Figur 3 dargestellt. Die Operationsverstärkerschaltung 12a umfasst einen ersten Widerstand 14a, einen zweiten Widerstand 15a und einen Operationsverstärker 16a, dessen Ausgang 17a unter Zwischenschaltung des ersten Widerstands 14a mit dessen positivem Eingang 18a elektrisch verbunden ist und unter Zwischenschaltung des zweiten Widerstands 15a mit dessen negativem Eingang 19a elektrisch verbunden ist. Die NIC-Schaltung 11a ist dazu ausgebildet, mit externer elektrischer Energie versorgt zu werden, wozu der Operationsverstärker 16a Anschlüsse 20a zum Anlegen einer externen Versorgungsspannung für den Operationsverstärker 16a aufweist. Eine entsprechende Spannungsversorgung ist der Übersichtlichkeit halber nicht dargestellt. Der positive Eingang 18a des Operationsverstärkers 16a ist mit einer Seite des Kondensators 9a elektrisch verbunden und der negative Eingang 19a des Operationsverstärkers 16a ist unter Zwischenschaltung des elektrisch regelbaren Widerstands 13a mit der anderen Seite des Kondensators 9a elektrisch verbunden.

Des Weiteren umfasst die elektrische Schaltung 4a einen parallel zu der NIC-Schaltung 11a geschalteten Verstärker 21a, vorliegend ein rauscharmer Vorverstärker, der dazu ausgebildet und/oder eingerichtet ist, ein Ausgangszeitsignal des elektrischen Schwingkreises 5a an der NIC-Schaltung 11a abzugreifen und zu verstärken, und einen Analog-Digital-Wandler 22a, der dazu ausgebildet und/oder eingerichtet ist, ein von dem Verstärker 21a eingangsseitig empfangenes analoges Ausgangszeitsignal in ein digitales Ausgangszeitsignal umzuwandeln und das digitale Ausgangszeitsignal ausgangsseitig auszugeben. Darüber hinaus weist die Haupt-Vorrichtung 2 eine als Sattelspule ausgebildete und die Schwingkreisspule 6a umgebende Hochfrequenzanregungsspule 23 auf, die dazu ausgebildet und/oder eingerichtet ist, einen Hochfrequenz-Anregungsimpuls in Form eines zeitlich begrenzten hochfrequenten magnetischen Wechselfelds zu erzeugen, dem das aktive Medium 8a ausgesetzt ist. Die sensitiven Achsen der Schwingkreisspule 6a und der Hochfrequenzanregungsspule 23 stehen zumindest im Wesentlichen senkrecht aufeinander. Außerdem umfasst die Haupt-Vorrichtung 2 eine Pump-Einrichtung 24, die dazu ausgebildet und/oder eingerichtet ist, X-Kernspins in einen Zustand negativer oder positiver Kernspinpolarisation zu pumpen.

Die Referenz-Vorrichtung 3 umfasst ebenfalls eine elektrische Schaltung 4b, die einen elektrischen Schwingkreis 5b, nämlich einen Parallelschwingkreis, aufweist. Der elektrische Schwingkreis 5b umfasst eine flache, kreisringförmige Schwingkreisspule 6b, die einen Aufnahmeraum 7b, in dem ein aktives Medium 8b während des Betriebs der Referenz-Vorrichtung 3 angeordnet ist, um mit der Schwingkreisspule 6b über Faradayinduktion wechselzuwirken, umgibt und die eine Induktivität L_{ref} aufweist. Die Schwingkreisspule 6b befindet sich in der Nähe, vorliegend unterhalb, der Schwingkreisspule 6a und innerhalb der Hochfrequenzanregungsspule 23. Außerdem umfasst der elektrische Schwingkreis 5b einen einstellbaren Kondensator 9b. Darüber hinaus weist die elektrische Schaltung 4b eine Ferritspule 10b auf, die mit der Schwingkreisspule 6b und dem Kondensator 9b in Reihe geschaltet ist. Des Weiteren umfasst die elektrische Schaltung 4b eine parallel zu dem Kondensator 9b geschaltete und als NIC-Schaltung 11b ausgebildete aktive elektronische Einrichtung, die zur aktiven Entdämpfung des elektrischen Schwingkreises 5b ausgebildet ist. Die NIC-Schaltung 11b umfasst die gleichen Komponenten wie die NIC-Schaltung 11a, weshalb zur Vermeidung von Wiederholungen auf die vorstehende Beschreibung der NIC-Schaltung 11a verwiesen wird. Die Bezugszeichen korrespondierender Komponenten der NIC-Schaltungen 11a und 11b sind mit dem Zusatz "a" bei Zugehörigkeit zur Haupt-Vorrichtung 2 und "b" bei Zugehörigkeit zur Referenz-Vorrichtung 3 versehen. Weiter umfasst die elektrische Schaltung 4b einen parallel zu der NIC-Schaltung 11b geschalteten Verstärker 21b, vorliegend einen empfindlichen Instrumentenverstärker, der dazu ausgebildet und/oder eingerichtet ist, ein Ausgangszeitsignal des elektrischen Schwingkreises 5b an der NIC-Schaltung 11b abzugreifen und zu verstärken, und einen Analog-Digital-Wandler 22b, der dazu ausgebildet und/oder eingerichtet ist, ein von dem Verstärker 21b eingangsseitig empfangenes analoges Ausgangszeitsignal in ein digitales Ausgangszeitsignal umzuwandeln und das digitale Ausgangszeitsignal ausgangsseitig auszugeben. Darüber hinaus ist ein aktiver Regelkreis 25 für die NIC-Schaltung 11b vorgesehen, der dazu ausgebildet ist, während des Betriebs der Referenz-Vorrichtung 3 eine Schwingungsamplitude des elektrischen Schwingkreises 5b zumindest bis auf eine zulässige Abweichung stabil auf einem vorgegebenen Wert zu halten. Der Regelkreis 25 umfasst eine Amplitudenmessschaltung 26, einen Amplitudenstabilisierungsregler 27 und eine Auswerteeinheit 28, die einerseits mit der Amplitudenmessschaltung 26 und andererseits mit dem Amplitudenstabilisierungsregler 27 verbunden ist und einen Addierer 29 umfasst. Der Verstärker 21b kann ebenfalls Teil des Regelkreises 25 sein. Die Amplitudenmessschaltung 26 ist mit dem Verstärker 21b verbunden und dazu ausgebildet und/oder eingerichtet, ein von dem Verstärker 21b abgegriffenes Ausgangszeitsignal von diesem zu empfangen. Der Amplitudenstabilisierungsregler 27 ist mit dem elektrisch regelbaren Widerstand 13b verbunden und dazu ausgebildet und/oder eingerichtet, die erfasste Schwingungsamplitude basierend auf dem Ergebnis eines in der Auswerteeinheit 28 durchgeführten Vergleichs der erfassten Schwingungsamplitude mit einer Sollamplitude As nachzuregeln, indem die von der NIC-Schaltung 11b bewirkte Entdämpfung über den elektrisch regelbaren Widerstand 13b nachgeregelt wird. Außerdem umfasst die Referenz-Vorrichtung 3 eine von der Pump-Einrichtung 24 der Haupt-Vorrichtung 2 technisch separierte weitere Pump-Einrichtung 24, die dazu ausgebildet und/oder eingerichtet ist, Y-Kernspins in einen Zustand negativer Kernspinpolarisation zu pumpen. In der Figur 1 ist aus Gründen der Übersichtlichkeit lediglich eine Pump-Einrichtung 24 angedeutet.

Ebenfalls Teil des Systems 1 ist ein Elektromagnet 30 mit einer zylindrischen Magnetspule 31 und einer damit verbundenen Stromquelle 32, der dazu ausgebildet ist, ein homogenes, statisches Magnetfeld B₀ zu erzeugen. Hierzu ist der Elektromagnet 30 vorliegend mit einem Shim-Spulensatz versehen, der aus Gründen der Übersichtlichkeit nicht dargestellt ist. Die Magnetspule 31 umgibt einen zylindrischen Spulenaufnahmeraum 33, innerhalb dessen die Schwingkreisspulen 6a und 6b sowie die Hochfrequenzanregungsspule 23 angeordnet sind. Hierbei ist die sensitive Achse der Hochfrequenzanregungsspule 23 senkrecht zur Richtung des Magnetfelds B₀ (z-Richtung in Figur 1) sowie senkrecht zur sensitiven Achse der Schwingkreisspule 6a (y-Richtung in Figur 1) und zur sensitiven Achse der Schwingkreisspule 6b orientiert. Darüber hinaus umfasst das System 1 eine Auswertevorrichtung 34 mit einem NIC-Schaltungs- und Kondensator-Steuerungs-Modul 35, einem Arbitrary-HF-Puls-Former/Generator-Modul 36, einem Datenaufnahme-Modul 37, einem Signal-Analyse/FFT-Modul 38 und einem Korrektur-Algorithmen-Modul 39. Die beiden Analog-Digital-Wandler 22a und 22b sind mit dem Datenaufnahme-Modul 37 der Auswertevorrichtung 34 verbunden. Der einstellbare Kondensator 9a und der elektrisch regelbare Widerstand 13a der Haupt-Vorrichtung 2 sind jeweils mit dem NIC-Schaltungs- und Kondensator-Steuerungs-Modul 35 der Auswertevorrichtung 34 verbunden. Außerdem weist das System 1 einen HF-Leistungs-Verstärker 40 auf, der einerseits mit dem Arbitrary-HF-Puls-Former/Generator-Modul 36 der Auswertevorrichtung 34 und andererseits mit der Hochfrequenzanregungsspule 23 verbunden ist.

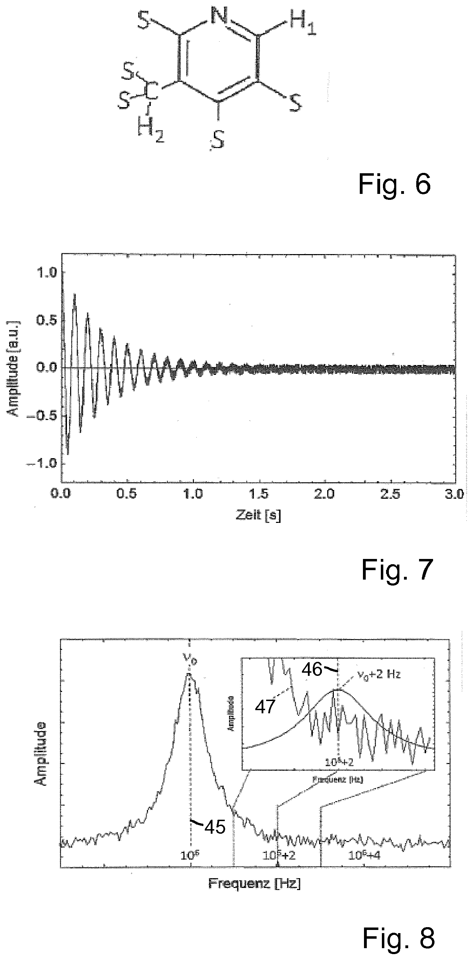

Das aktive Medium 8a der Haupt-Vorrichtung 2 umfasst Moleküle mit X-Kernspins und das aktive Medium 8b der Referenz-Vorrichtung 3 umfasst Atome und/oder Moleküle mit Y-Kernspins. Die Kernspinsorten X und Y unterscheiden sich. Konkret weist die Kernspinsorte Y ein gyromagnetisches Verhältnis ungleich der Kernspinsorte X auf. In der vorliegend beschriebenen Ausführungsform steht X für ¹H und umfasst das aktive Medium 8a der Haupt-Vorrichtung 2 ¹H-RASER-aktive Moleküle mit der in Figur 6 dargestellten Struktur, und steht Y für ¹⁹F oder ³He. Es versteht sich, dass in anderen Ausführungsformen Moleküle mit einer anderen Struktur zum Einsatz kommen können. Mittels des Elektromagneten 30 lässt sich zumindest ein Teil der X-Kernspins und ein Teil der Y-Kernspins in Richtung des Magnetfelds B₀ des Elektromagneten 30 ausrichten. Die Haupt-Vorrichtung 2 ist dazu in der Lage, ein Haupt-Messsignal, konkret ein Haupt-Ausgangszeitsignal, zu erfassen und an die Auswertevorrichtung 34 bereitzustellen. Auf ähnliche Weise ist die Referenz-Vorrichtung 3 dazu in der Lage, ein amplitudenstabilisiertes Referenz-Messsignal, konkret ein amplitudenstabilisiertes Referenz-Ausgangszeitsignal, zu erfassen und an die Auswertevorrichtung 34 bereitzustellen. Das Referenz-Ausgangszeitsignal dient dann als Referenz zum Korrigieren von durch Magnetfeldschwankungen bedingten Störungen in dem Haupt-Ausgangszeitsignal.

Figur 4 zeigt eine alternativ ausgestaltete aktive elektronische Einrichtung der Haupt-Vorrichtung 2 und der Referenz-Vorrichtung 3. Der einzige Unterschied zu der in Figur 3 dargestellten aktiven elektronischen Einrichtung besteht darin, dass ein spezieller elektrisch regelbarer Widerstand 13a,b, nämlich ein elektrisch regelbarer Widerstand 13a,b in Form eines Feldeffekttransistors vorgesehen ist. Der Feldeffekttransistor umfasst in üblicher Weise einen Gate-Anschluss 41, an den eine Steuerspannung anlegbar ist.

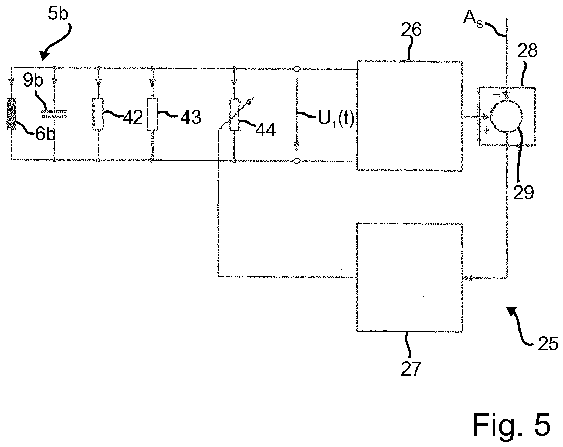

Figur 5 zeigt eine zur Veranschaulichung dienende schematische vergrößerte Ansicht von Komponenten der Referenz-Vorrichtung 3 des Systems 1. Dargestellt ist der elektrische Schwingkreis 5b bestehend aus der Schwingkreisspule 6b und dem einstellbaren Kondensator 9b. Die Einstellbarkeit des Kondensators 9b ist in der Figur 5 nicht explizit nochmals eingezeichnet. Zusätzlich ist ein positiver elektrischer Leitwert G₁, der die ohmschen Verluste der Schwingkreisspule 6b und des Kondensators 9b modelliert, in Form eines parallel zu dem Kondensator 9b geschalteten ersten Widerstandssymbols 42 angedeutet. Ein erster negativer elektrischer Leitwert - G₂, der die Verstärkung durch induzierte Emission beschreibt, ist in Form eines parallel zu dem ersten Widerstandssymbol 42 geschalteten zweiten Widerstandssymbols 43 angedeutet. Zuletzt ist ein zweiter negativer elektrischer Leitwert - G₃, der durch die NIC-Schaltung 11b erzeugt wird, in Form eines parallel zu dem zweiten Widerstandssymbol 43 geschalteten dritten Widerstandssymbols 44, genauer gesagt eines Symbols für einen regelbaren Widerstand, angedeutet. Allgemein gilt, dass der elektrische Leitwert als Kehrwert des ohmschen Widerstandes definiert ist. Es sei angemerkt, dass auch für die Haupt-Vorrichtung 2 die elektrischen Leitwerte G₁, -G₂, -G₃ entsprechend angedeutet werden können. Darüber hinaus ist der Regelkreis 25 der Referenz-Vorrichtung 3 dargestellt sowie eine abgegriffene beziehungsweise abzugreifende Ausgangsspannung u₁(t) des elektrischen Schwingkreises 5b angedeutet. Nicht dargestellt in Figur 5 sind der Verstärker 21b und der Analog-Digital-Wandler 22b. Darüber hinaus wird hier zur Vereinfachung angenommen, dass die Referenz-Vorrichtung 3 keine Ferritspule 10b aufweist.

Damit die elektrische Schaltung 4b schwingt, muss im Allgemeinen gelten, dass sich die positiven und negativen Leitwerte kompensieren: G₁ - G₂ - G₃ = 0. In einer praktischen Realisierung gilt jedoch: G₁ - G₂ - G₃ < 0, so dass die elektrische Schaltung 4b, genauer gesagt der elektrische Schwingkreis 5b, in jedem Fall anschwingt. Die Amplitude stabilisiert sich insbesondere automatisch aufgrund vorhandener nichtlinearer Effekte. Hierbei ist die Larmorfrequenz der Y-Kernspins durch f_{y} = γ_{Y} B₀ = γ_{19F} B₀ gegeben, die im Idealfall der On-Resonanz gleich der Frequenz f₀ = 1/(2π (Lref C_{ref})^{1/2}) des Referenz-Schwingkreises 5b ist. Bei leichten Schwankungen des B₀-Feldes verändert sich die Frequenz f_{y} = γ_{Y} B₀, sodass f_{y} ungleich f₀ ist, und die etwas kleinere Amplitude des RASER-Y-Kern-Referenzsignals wird durch Nachregelung des elektrischen Leitwerts - G₃ auf den Sollwert Aₛ stabilisiert.

Im Folgenden wird ein Ausführungsbeispiel eines erfindungsgemäßen Verfahrens zum Betrieb des erfindungsgemäßen Systems 1 gemäß Figur 1 beschrieben.

Bei der NMR-Spektroskopie ist es ein wichtiges Ziel, zwei zentrale Leistungsmerkmale, einerseits das Signal zu Rausch Verhältnis (SNR) und andererseits die Genauigkeit der Messung von Linienpositionen um weit mehr als den Faktor 100 zu verbessern. Beide Leistungskriterien werden gut erfüllt von Hochfeld-NMR-Spektrometern, die heutzutage mit supraleitenden Magneten im Bereich B₀ = 10 T operieren. Das hohe Feld B₀ des supraleitenden Magneten ist zeitlich extrem stabil (Feldfluktuationen << 10⁻⁹/h) und ist zudem unter erheblichen Aufwand (Shimm-Technology) extrem homogen, typischerweise wenige ppb (10⁻⁹) bezogen auf das Probenvolumen. Prinzipiell ist das SNR der Standard-NMR-Spektroskopie limitiert durch die Boltzmann-Polarisation P_{B} der Kernspins, die für Protonen (¹H Spins) bei 10 T und bei Raumtemperatur nur P_{B} = 3 x 10⁻⁵ beträgt (SNR ∼ P_{B}). Eine weitere prinzipielle Grenze der Genauigkeit der NMR-Spektroskopie ist durch die endliche Linienbreite w = 1/(πT₂) gegeben, welche das Vermögen begrenzt zwei dicht benachbarte Linien im NMR-Spektrum zu trennen (spektrale Auflösung). Beispielsweise ist bei 10 T und für ¹H-Spins in Flüssigkeiten die gemessene Linienbreite w = 1Hz, d.h. zwei Linien im Spektrum mit Frequenzabstand Δν <1 Hz lassen sich nicht mehr trennen. Falls Δν>1 Hz kann man beide Linienpositionen mit einer Genauigkeit bestimmen, die durch das SNR, die Detektionsbandbreite δν_{d} des NMR-Resonators und die Messzeit Tₘ einer einzelnen NMR-Messung (Tₘ beträgt mehrere T₂ Zeiten) begrenzt ist. Diese Grenze ist gegeben durch die sogenannte Cramer's Rao Beziehung, welche die Standardabweichung δσ für eine Frequenzmessung des Linienmaximums begrenzt auf δσ =Sqrt(3) /(π SNR Sqrt(δν_{d}) Tₘ^{3/2}). Kurz gesagt, um eine extrem genaue Bestimmung der Linienpositionen in einem NMR-Spektrum zu ermöglichen, d.h. für ein sehr kleines δσ, braucht man sowohl ein großes Produkt SNR x Sqrt(δν_{d}) als auch eine lange Messzeit Tₘ.

Mit dem Ausführungsbeispiel eines erfindungsgemäßen Systems 1 gemäß Figur 1 werden beide Leistungsmerkmale der NMR-Spektroskopie, d.h. das SNR und die Messgenauigkeit der Linienpositionen, um mehrere Größenordnungen verbessert. Dabei kommt anstatt eines teuren und immobilen supraleitenden Hochfeldmagneten ein weniger teurer und mobiler Elektromagnet (10⁻⁴ T < B₀ < 10⁻¹ T) zum Einsatz, dessen intrinsische B₀-Feldschwankungen typischerweise weit mehr als 1 ppm/ min betragen.

Das erfindungsgemäße System 1 realisiert insbesondere die folgenden drei Operationsmoden: (a) Ein NIC-gesteuertes NMR-Spektrometer (1. Mode), (b) ein amplituden-geregelter single-mode Fluor-(¹⁹F)-RASER (2. Mode), der als hochgenaue Referenz dient, für ein (c) NIC-gesteuertes Proton-(¹H)-RASER-Spektrometer (3. Mode). Der Referenz-RASER kann auch als empfindlicher Magnetfeldsensor dienen. Als Alternative für den ¹⁹F-Referenz-RASER kann auch ein SEOP-gepumpter ³He-RASER (bekannt als ³He-Zeeman-MASER) eingesetzt werden. Die drei Operationsmoden dienen dazu chemische und/oder J-Kopplungsinformation von RASER-aktiven Molekülen mit einer Genauigkeit zu messen, die wesentlich besser als die Genauigkeit ist, die durch Standard-NMR-Spektroskopie erzielt werden kann. Die Haupt-Vorrichtung 2 kann auch als aktiv entdämpftes ¹H-RASER/NMR-Spektrometer bezeichnet werden. Die Referenz-Vorrichtung 3 kann auch als ¹⁹F (³He)-Referenz-RASER bezeichnet werden.

Die Kernspins der ¹⁹F- (³He-)Atome werden mittels para-Wasserstoff und SABRE oder mittels anderer Methoden insbesondere der Hyperpolarisation, wie z.B. SEOP oder DNP, in einen Zustand negativer Kernspin-Polarisation P < 0 gepumpt. Negative Werte von P für einen Kernspin ½ bedeuten eine Populationsinversion zwischen den beiden Zeeman Energieniveaus. Geeignete Moleküle/Atome für den mit SABRE gepumpten ¹⁹F-Referenz-RASER 3 sind z.B. Acetonitril (CF₃-CN) in flüssigem ds Methanol unter Anwesenheit eines geeigneten Ir-Katalysator (z.B. IMes). Für den mittels SEOP gepumpten ³He-Referenz-RASER 3 werden geeignete zirkular polarisierte LASER verwendet, die Rb-Metalldampf bei ca. 180 °C in kleinen Glaszellen (-0.2 cm³) optisch pumpen. In der Glaszelle befinden sich weiterhin einige bar ³He-Gas und ca. 10 mbar N₂-Gas (Quenchgas). Die Frequenz des Referenz-RASERs 3 wird bestimmt durch die Induktivität L_{ref} der Schwingkreisspule 7b und die externe verlustarme Induktivität L_{F2} (falls nötig) der Ferritspule 10b in Kombination mit der variablen Kapazität C₂ des Kondensators 9b. Die Schwingungsfrequenz des Resonators v_{R} des Referenz-RASERs 3 ist auf die Larmorfrequenz ν₀ = γ_{19F} B₀ der ¹⁹F-Kernspins (gyromagnetisches Verhältnis γ_{19F} = 4.008 kHz/G) oder im Falle von ³He auf ν₀ = γ_{3He} B₀ (γ_{3He} = -3,141 kHz/G) abgestimmt. Ohne diese Abstimmung würde keine RASER-Aktivität der ¹⁹F- oder ³He-Kernspins zustande kommen. Durch entsprechende aktive Entdämpfung des gesamten Resonators (L_{ref}, L_{F2}, C₂) des Referenz-RASERs 3 mittels der NIC-Schaltung 11b kommt es beim Überschreiten der RASER-Schwelle zu einer kontinuierlichen RASER-Oszillation bei der ¹⁹F- (oder ³He-) Resonanzfrequenz, dessen Amplitude durch eine aktive Regelung mittels des Regelkreises 25 stabil auf einen vorgegebenen Wert gehalten wird. Mittels des elektrisch regelbaren Widerstands 13b der NIC-Schaltung 11b wird die Güte des elektrischen Schwingkreises 5b geregelt. Die Resonanzfrequenz des elektrischen Schwingkreises 5b der Referenz-Vorrichtung 3 ist ca. 6 % für ¹⁹F (26% für ³He) von der ¹H-Larmorfrequenz (ν₀ = γ_{H}B₀, γ_{H} = 4.257 kHz/G) des ¹H-RASER-Spektrometers 2 entfernt. Da der ¹H-RASER im Betrieb bei z.B. ν₀ = 1 MHz einen schmalbandigen Resonator besitzt (< 1000 Hz Bandbreite für Q > 1000) kann der störende Einfluss des ¹⁹F-Referenz-RASER-Signals bei ca. 941 kHz (738 kHz bei ³He) auf das ¹H-RASER-Signal vernachlässigt werden. Der Referenz-RASER 3 kann auch als hochgenauer Magnetfeldsensor eingesetzt werden, und dient hier zur Online-Messung kleinster Magnetfeldfluktuationen, die immer aufgrund äußerer magnetischer Störungen oder von Schwankungen der Stromversorgung (Stromkonstanter mit ∼1 ppm/h Schwankungen) des Elektromagneten 30 auftreten.

Das ¹H-RASER/NMR-Spektrometer 2 umfasst die Schwingkreisspule 6a mit einer Induktivität L₁ und einen externen hochgütigen Resonator, umfassend eine Transferlinie, die Ferritspule 10a mit einem verlustarmen gewickelten Ferritkern und mit der Induktivität L_{F1}, den einstellbaren Kondensator 9a mit der Kapazität C₁ und parallel dazu die NIC-Schaltung 11a zur aktiven Entdämpfung des gesamten (L₁+L_{F1})C₁ Resonators. Die Resonanzfrequenz des ¹H-RASER-Schwingkreises kann mittels des Kondensators 9a auf die Frequenz ν_{R} = 1/(2π Sqrt((L₁+L_{F1})C₁)) eingestellt werden. Mittels des elektrisch regelbaren Widerstandes 13a der NIC-Schaltung 11a kann der Gütefaktor Q des Resonators auf im Prinzip beliebig hohe Werte eingestellt werden, solange die Anordnung nicht von alleine schwingt. Der Verstärker 21a verstärkt die NMR- oder RASER-Signale, welche anschließend von dem Analog-Digital-Wandler 22a und der Auswertevorrichtung 34 analysiert werden können.

Zur Demonstration der hohen Genauigkeit, die mit einem solchen NIC-gesteuerten, aktiv entdämpften ¹H-RASER/NMR-Spektrometer 2 erzielt werden kann, kann ohne Beschränkung der Allgemeinheit ein gepumptes Ensemble von Molekülen in dem aktiven Medium 8a angenommen werden, dessen Protonpolarisation P negativ oder positiv sein kann. Durch das Pumpen, vorliegend mit einem Hyperpolarisationsverfahren (SABRE, DNP, SPINOE, etc..), mittels der Pump-Einrichtung 24 der Haupt-Vorrichtung 2 kann der Betrag von P um mehrere Zehnerpotenzen größer sein als die in einem großen Magnetfeld und bei 300 K erzielte Boltzmannpolarisation im thermischen Gleichgewicht. Sowohl der ¹⁹F-Referenz-RASER 3 als auch das ¹H-RASER/NMR-Spektrometer 2 können mit SABRE gepumpt werden. Es ist auch möglich, dass der ³He-Referenz-RASER 3 mit SEOP und das ¹H-RASER/NMR-Spektrometer 2 mit SABRE gepumpt wird. Zur Verdeutlichung des Prinzips kann weiterhin angenommen werden, dass das ¹H-NMR-Spektrum bei ν₀=1 MHz Resonanzfrequenz (B₀ = 234,9 G) durch zwei chemisch verschobene NMR-Linien 45, 46 charakterisiert ist. So ein Spektrum ergibt sich beispielsweise für das in Figur 6 dargestellte Molekül (Mol1) mit einer Protonenspezies H₁ (ortho-Ringproton) und einer um 2 ppm verschobenen Protonenspezies H₂ (innerhalb einer CH₃ Gruppe) unter Vernachlässigung der in diesem Beispiel sehr kleinen homo-nuklearen J-Kopplung. Die chemische Verschiebungsdifferenz zwischen Proton H₁ und H₂ ist 2 Hz, beträgt also δ_{H1} - δ_{H2} = 2 ppm. Die Gruppe "S" in Figur 6 ist ein Substituent ohne Kernspin. Weiterhin sei die Amplitude der ersten Linie 45 der Spezies H₁ bei genau ν₀ = ν_{H1} = 10⁶ Hz 1000-mal größer als die Amplitude der Linie 46 von Spezies H₂, die verschoben bei (ν_{H2} = ν₀ + 2 Hz) liegt (siehe Figur 8). Die Linienbreite beider ¹H-Linien sei w = 1 Hz. Der Faktor 1000 Unterschied in der Amplitude der beiden ¹H-Linien kann z.B. durch erheblich unterschiedliche SABRE-¹H-Pump-Effizienzen der beiden Spezies H₁ und H₂ erklärt werden. Eine andere Möglichkeit, wie ein Spektrum mit sehr unterschiedlichen Linienamplituden entstehen kann, ist beispielsweise gegeben durch eine einzelne ¹H-Spezies (mit einer Hauptlinie), die durch hetero-nukleare J-Kopplung an einen seltenen Kern (z.B. ¹³C mit 1% natürlicher Häufigkeit) im Molekül in kleinere Satellitenlinien (in diesem Fall in ein Doublet) aufspalten. Die Amplituden beider Satelliten sind verglichen mit der ungekoppelten Hauptlinie ca. um den Faktor 200 kleiner.

Im ersten Schritt geht es um die Messung eines groben ¹H-NMR-Spektrums, um ungeachtet des Vorzeichens der Polarisation P die ungefähren Positionen und Amplituden der größten ¹H-Resonanzen zu erfassen. Hierzu wird zunächst mit der NIC-Schaltung 11a der Gütefaktor des ¹H-NMR/RASER-Spektrometers 2 unterhalb der RASER-Schwelle (hier angenommen als Qₛ = 100) auf den kleinen Wert Q = 40 eingestellt. Die Detektionsbandbreite des Resonators im Frequenzraum beträgt δν_{d} = ν₀/Q = 10⁶ Hz/40 = 25 kHz. Diese relativ große Bandbreite bedeutet, dass alle NMR-Linien 45, 46, die bei 1 MHz in einem Bereich von ca. 200 Hz liegen, detektiert werden können. Das Arbitrary-HF-Puls-Former/Generator-Modul 36 der Auswertevorrichtung 34 kann beliebig geformte HF-Pulse erzeugen (z.B. mit gaußförmigen oder rechteckigen Einhüllenden), die als Signalquelle zur Anregung der polarisierten ¹H-Kerne innerhalb der Probe dienen. Nach einem 90°-Anregungspuls mit der Hochfrequenzanregungsspule 23 erhält man einen freien Induktionszerfall (FID) von Mol1, dessen Zeitsignal von der Schwingkreisspule 6a erfasst wird (siehe Figur 7) und dessen fouriertransformiertes ¹H-NMR-Spektrum von Mol1 in Figur 8 dargestellt ist. Der ¹H-FID gemessen bei v₀ = 10⁶ Hz ist mit 10 Hz-Off-Resonanz abgemischt. Für diese eine Messung sieht man im Spektrum nur eine Linie 45 von H₁ bei ν₀ = γ_{H} • B₀ = 10⁶ Hz mit einer Linienbreite von w = 1Hz. Die Linienbreite berechnet sich über w=1/(π T₂) mit T₂ ∼ 0,3 s. Das Signal-Rausch-Verhältnis von Linie 45 sei angenommen als SNR=10, d.h. die um den Faktor 1000 kleinere zweite Linie 46 von H₂ bei (10⁶ +2) Hz kann mit einer Einzelmessung aufgrund des kleinen SNR=0.01 nicht detektiert werden und geht im Rauschen 47 unter. In dem Einschubfenster in Figur 8 ist das Spektrum von Linie 46 mit um einen Faktor 100 verstärkter Skala der Amplitudenachse dargestellt. Darüber hinaus ist das Rauschen 47 um einen Faktor 10 verstärkt dargestellt. Die benötigte Messzeit der kleinen Linie 46 kann folgendermaßen abgeschätzt werden: Bei einer angenommenen longitudinalen Relaxationszeit T₁ ∼ 4 s und einer Wiederholzeit von 20 s pro Messung (5 x T₁-Zeit) braucht man mindestens eine Messzeit weit länger als 10⁶ s um die kleinere Linie 46 mit genügend hohem SNR - 10 messen zu können, und selbst in diesem Fall kann man die chemische Verschiebungsdifferenz nur sehr ungenau bestimmen. Bei Q = 40 und bei 1 MHz können also ¹H-Linien mit kleiner Amplitude nur mit erheblichen Aufwand oder überhaupt nicht gemessen werden.

Falls P > 0 ist, wie etwa P_{H1} = 10³ P_{H2} > 0, kann man im nächsten Schritt das SNR des aktiv entdämpften ¹H-NMR-Spektrometers 2 erheblich steigern, indem man den Gütefaktor Q mittels der NIC-Schaltung 11a beispielweise auf Q = 4x10⁵ steigert. Wegen der positiven Polarisation gibt es keine RASER-Aktivität, aber laut Theorie ist SNR ∼ Sqrt(Q), und daher steigert sich das SNR relativ zur vorhergehenden NMR-Messung bei Q = 40 um den Faktor Sqrt(4 x10⁵/ 40) = 100. Da bei Q = 40 das SNR =10 für die große Linie 45 angenommen wurde, ist jetzt bei Q = 4 x 10⁵ das SNR = 1000 für die große Linie 45 und SNR = 1 für die kleine Linie 46. Die Frequenzbandbreite der Detektion ist jetzt reduziert auf δν_{d} =ν₀/Q =10⁶ Hz/4x10⁵ = 2.5 Hz. Somit kann man jetzt gerade noch beide Linien 45, 46 mit einer einzelnen Messung detektieren, falls die Zentralfrequenz des Spektrometers bei v_{R} = (10⁶ +2) Hz liegt. Man kann bei Q = 4 x 10⁵ durch Mittelung von wenigen Einzelmessungen die Position beider Linien 45, 46 grob bestimmen, aber die Genauigkeit ist immer noch stark limitiert, insbesondere wegen des niedrigen SNR ∼ 1 und der Linienbreite von w = 1 Hz der kleinen Linie 46. Zumindest kennt man jetzt die grobe Linienposition der beiden NMR-Linien 45, 46.

Im zweiten Schritt kann angenommen werden, dass das Verfahren der Hyperpolarisation (z.B. SABRE) auch negative Polarisation P < 0, d.h. eine Besetzungsinversion von mindestens einer Protonenspezies im Zielmolekül produziert. Dies ist der Fall für sehr viele Moleküle (z.B. stickstoffhaltige organische Moleküle, siehe Figur 6), die mit SABRE gepumpt werden und P < 0 (- 10⁻⁵ < P < - 10⁻¹) erzielen für einen relativ großen Magnetfeldbereich 0 T < B₀ < 10⁻¹ T. Für das technisch erheblich aufwändigere DNP-Verfahren erreicht man P < 0 mit ausreichender Polarisation nur bei größeren Magnetfeldern und tieferen Temperaturen, und überdies muss die Probe freien Radikale enthalten (mit einem Elektronenspin gekoppelt an die Kernspins der Zielmoleküle). Im vorliegenden Beispiel gilt: P_{H1} = 10³ P_{H2} < 0.

Um eine RASER-Aktivität der großen Linie 45 zu erzwingen, stimmt man den Resonanzkreis des ¹H-RASER/NMR-Spektrometers 2 mittels des einstellbaren Kondensators 9a auf genau das Maximum der großen NMR-Linie 45 ein, also auf ν₀= ν_{H1} = 10⁶ Hz, d.h. für die RASER-Resonanzfrequenz gilt: ν_{R} = v₀ = 10⁶ Hz, und erhöht mit der NIC-Schaltung 11a die Güte Q soweit, bis die ¹H-RASER-Aktivität der großen Linie 45 einsetzt. Angenommen die Schwelle liegt für die große Linie 45 bei Qₛ = 100, dann kann das ¹H-RASER-Signal nach dem Einschwingen der RASER-Oszillation in ein stationäres Gleichgewicht mit einer beliebig langen Messzeit Tₘ aufgenommen werden. Die NIC-Schaltung 11a wird also auf Qs=100, die RASER-Schwelle von H₁, eingestellt. Die zweite NMR-Linie 46 kann in diesem Modus nicht RASER-aktiv werden, da die Schwelle 1000-mal oberhalb der Schwelle der ersten großen NMR-Linie 45 liegt. Denn es gilt: Q_{S} = 100 Q_{S} (H₂) = 10⁵.

Grundsätzlich gilt für die negative Kernspinpolarisation Pₛ, ab der der RASER anfängt sich selbst zu erregen (die sog. RASER-Schwelle), der wichtige Zusammenhang Pₛ ∼ (-1)/(N Q T₂*), wobei N die Zahl der Kernspins im RASER-aktiven Volumen, Q die Güte und T₂* die effektive transversale Relaxationszeit (1/T₂* = 1/T₂ + 1/Tₚ, 1/Tₚ = Pumprate) bedeuten. Man beachte den negativen Vorfaktor (-1), der eine negative Polarisation bzw. eine Besetzungsinversion andeutet.

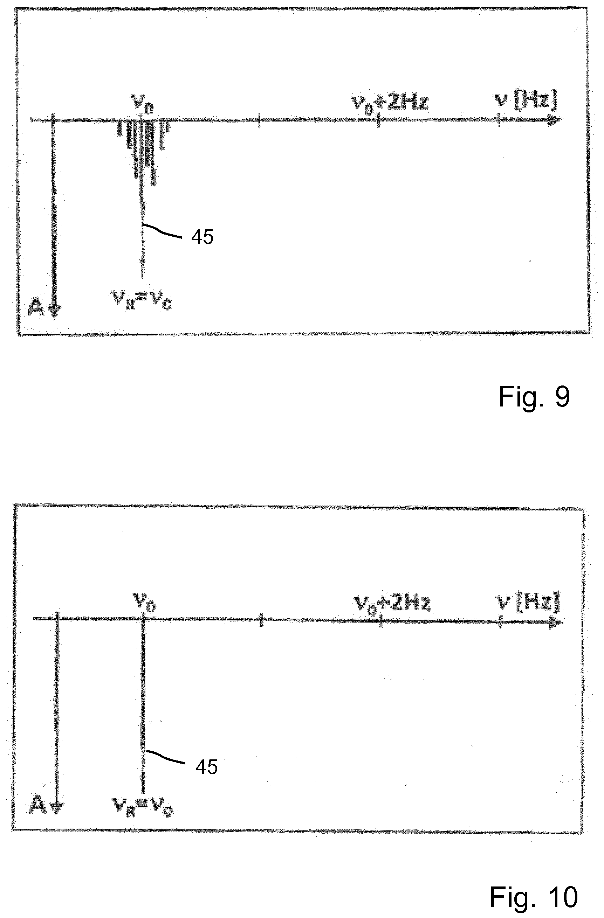

Nach einer Fourier-Transformation des ¹H-RASER-Signals mit beispielsweise Tₘ = 100 s ergibt sich ein ¹H-RASER-Spektrum (siehe Figur 9), welches je nach Magnetfeldfluktuationen aus einer Superposition von vielen schmalen Linien besteht. In Figur 9 ist zu erkennen, dass die erste, große Linie 45 durch Magnetfeldfluktuationen verbreitert ist. Wie ebenfalls zu erkennen ist, ist bei ν₀ + 2 Hz keine zweite, kleine Linie 46 vorhanden, da diese RASER-inaktiv ist. Die Linien in Figur 9 sind negativ (A < 0), da P_{H1} < 0. Dieses verbreiterte Spektrum kann unter Zuhilfenahme des ¹⁹F- (oder ³He-) Referenzspektrums, welches durch die exakt gleichen Magnetfeldfluktuation verbreitert ist, vollständig korrigiert werden. Ein Verfahren zur Korrektur von Magnetfeldschwankungen ist im Supplementary der Druckschrift von M. Süfke et al., Nature Physics, DOI: 10.1038/NPHYS4076 beschrieben. Nach der Korrektur ergibt sich ein extrem schmales ¹H-RASER-Spektrum mit einer Linie 45, dessen Maximum mit einer Genauigkeit von δσ_{H1} ≈ 0,2 µHz, also weit besser als 1 µHz, bestimmt werden kann (siehe Figur 10). Diese extrem hohe Genauigkeit der Frequenzbestimmung des Linienmaximums ergibt sich aus der Cramers Rao Beziehung mit einer angenommenen Messzeit Tₘ =100 s, Bandbreite δv_{d} = ν₀/Qₛ=10⁴ Hz und einem SNR(H₁) ~ 30. Hierbei gilt für die Standardabweichung des Maximums von Linie 45: δσ = Sqrt(3)/(π SNR Sqrt(δv_{d})(Tₘ)^{3/2}).

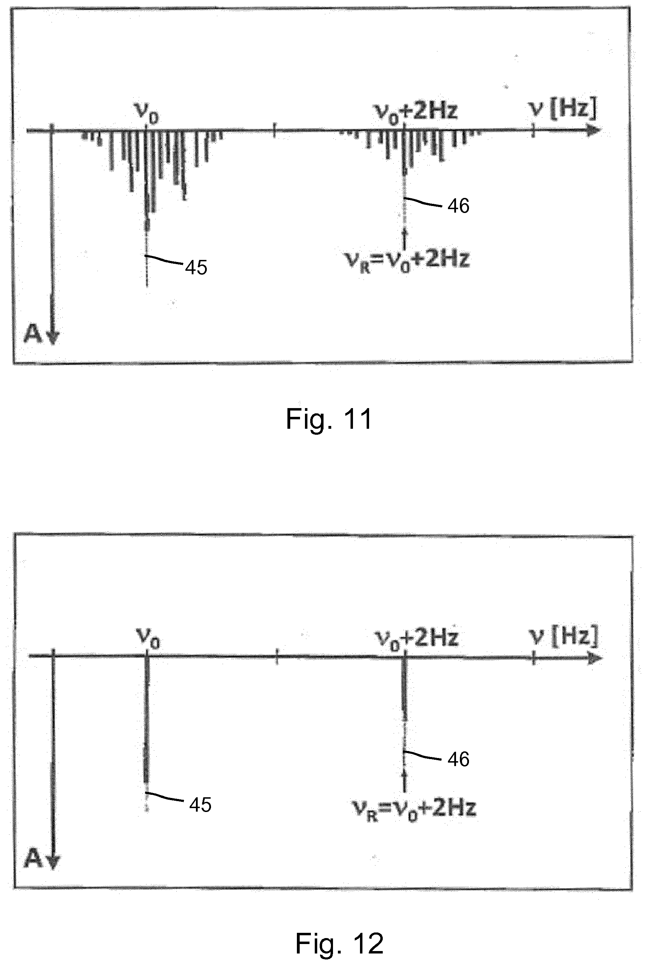

Im dritten Schritt sollen weitere NMR-Linien, in unserem Fall Linie 46 mit der um den Faktor 1000 kleineren Amplitude, mit dem ¹H-RASER/NMR-Spektrometer 2 gemessen werden. Hierzu wird das ¹H-RASER/NMR-Spektrometer 2 verstimmt, beispielsweise durch Veränderung der Kapazität C₁ des Kondensators 9a auf (10⁶ +5) Hz, und dann mithilfe der NIC-Schaltung 11a die Güte Q des Resonanzkreises 5a so knapp wie möglich unter die Selbsterregung des Resonanzkreises 5a, beispielsweise auf Q = 10⁷, erhöht. Bei einer ¹H-Resonanzfrequenz von ν₀ = 10⁶ Hz ist die Frequenzbandbreite des RASER-Resonanzkreises 5a jetzt δν_{b} = ν₀/Q = 0,1 Hz. Mittels Variation der Kapazität C₁ des Kondensators 9a kann nun in Frequenzintervallen von 0,1 Hz die ¹H-Resonanzfrequenz schrittweise erniedrigt werden (also von (10⁶+5) Hz auf 10⁶ Hz in 0,1 Hz Schritten). Insbesondere wenn die Resonanzfrequenz von Linie 46 bei (10⁶+2) Hz erreicht ist, kann diese anfangen RASER-aktiv zu werden, da deren RASER-Schwelle bei einem Qₛ(H₂) = Qₛ(H₁) x 1000 =100 x 1000=10⁵ liegt, also für ein eingestelltes Q = 10⁷ um den Faktor 100 überschritten ist. Das hohe Q = 10⁷ hat nun mehrere Effekte. Erstens wird das Signal-Rausch-Verhältnis bei (10⁶ +2) Hz von Linie 46, deren SNR(H₂) ∼ 0,03 bei Qₛ = 100 beträgt, um den Faktor Sqrt(10⁷/100) = 330 vergrößert, d.h. SNR(H₂) = 330 x 0.03 ∼ 10 für die RASER-aktive Linie 46. Zweitens wird durch die sehr schmale Bandbreite von δν_{b} = 0,1 Hz das RASER-Signal der Linie 45 stark unterdrückt. In unserem Fall, d.h. für lorentzförmige Spektrallinien, beträgt der Unterdrückungsfaktor 1/(1+(2 Hz/0.1Hz)²) ∼ 1/400. Eine mathematische Analyse zeigt, dass unter geeigneten Bedingungen die beiden RASER-Linien 45, 46 koexistieren können, d.h. nach der Messzeit Tₘ und anschließender Fouriertransformation ergibt sich ein RASER-Spektrum mit zwei Linienstrukturen mit denselben Frequenzschwankungen (siehe Figur 11). Hierbei sind die verbreiterten Strukturen von Linie 45 und Linie 46 selbstähnlich. Nach Korrektur mit der ¹⁹F-Referenz (Figur 12) resultiert ein Spektrum mit zwei ultra-schmalen Linien 45, 46, d.h. Linien 45, 46 mit einer Linienbreite im Milli-Hertz-Bereich oder weniger, dessen Frequenzdifferenz ziemlich genau der chemischen Verschiebungsdifferenz (hier 2 Hz) der beiden Linien 45, 46 entspricht. Sehr kleine nichtlineare Frequenzveschiebungen, die bei Koexistenz von zwei oder mehreren Moden auftreten (hier einige mHz, siehe Theorie des multi-mode RASERs), können aus mehreren Messungen bei verschiedenen Resonanzfrequenzen ν_{R} eliminiert werden. Die Korrektur mit der ¹⁹F-Referenz ist auch dann möglich, falls beide Strukturen in Figur 11 überlappen. Somit kann in dem vorliegenden Beispiel die Frequenzdifferenz der beiden Linien 45, 46, d.h. die chemische Verschiebungsdifferenz, auf wenige µHz Absolutgenauigkeit bestimmt werden. Diese Absolutgenauigkeit ist hier hauptsächlich durch die Genauigkeit der Bestimmung des Maximums von Linie 46 bestimmt. Für Tₘ = 1000 s, δν_{b} = 0,1 Hz und SNR(H₂) = 10 ergibt sich aus der Cramers Rao Beziehung als Standardabweichung für Linie 46: δσ_{H2} ∼ 6 µHZ.

Für den Fall, dass beide RASER-Linien 45, 46 nicht koexistieren, dann kann die Position jeder RASER-Linie 45, 46 für sich alleine in zwei getrennten Messungen (mit verschiedenen Q) bestimmt werden und es gibt in diesem Fall auch keine nichtlinearen Verschiebungseffekte. Die absolute Frequenzdifferenz der beiden Linien 45, 46 kann trotzdem mithilfe der ¹⁹F-Referenz mit höchster Genauigkeit bestimmt werden. Die zwischen den beiden zeitlich versetzten RASER-Messungen stattgefundenen Magnetfeldschwankungen können mit der ¹⁹F-Referenz exakt bestimmt werden und aus den Spektren vollständig eliminiert werden. Da die Messzeit Tₘ sehr lange sein kann (Tₘ∼10000 s), ist die Absolutgenauigkeit der Messung von wichtigen NMR Parametern (z.B. chemische Verschiebungen oder J-Kopplungen) im 100 nHz Bereich durchaus denkbar. Die praktisch erzielbare Grenze der Genauigkeit ist bisher nicht bekannt. Ultimativ sollte die Grenze durch die Heisenbergsche-Energie-Zeit-Unschärferation festgelegt sein, wobei zur Zeit noch unklar ist, ob man mit einem RASER-Spektrometer in die Nähe dieser ultimativen Grenze gelangt. Offensichtlich ist, dass das erfindungsgemäße System 1 verglichen mit der NMR-Spektroskopie im Hochfeld ein erheblich besseres SNR besitzt und überdies eine erheblich verbesserte Genauigkeit der Bestimmung von relevanten NMR-Parametern erlaubt.

Offen ist die Frage, ob man mit dem System 1 aus Figur 1 mit frequenzselektiver schmalbandiger Selektion von unterschiedlichen RASER Moden auch zwei (oder mehrere) Linien trennen kann, deren Frequenzdifferenz geringer als die Linienbreite w ist. Eine neuere mathematische Analyse im Einklang mit der Physik des Lasers zeigt, dass für eine Bandbreite des RASER-Resonators δν_{b} >> Linienabstand und falls die Differenz der Maxima zweier Linien (= Linienabstand) innerhalb ihrer Linienbreite liegen eine Trennung beider Linien unmöglich ist. Ob dies für δv_{b} < Linienseparation der Fall ist, ist nach Auffassung der Anmelderin eine offene Frage. Auf den ersten Blick scheint die Heisenbergsche Unschärfebeziehung verletzt zu sein, aber in der Quantenoptik benutzt man für die LASER-Interferometer sogenannte "squeezed states", die eine Messung z.B. des Ortes mit einer Unbestimmtheit genauer als die Unschärferelation ermöglicht, dies aber auf Kosten der Impulsunschärfe. Insgesamt ist also die Heisenberg-Ort-Impuls-Unschärferelation erfüllt.

Das vorstehend beschriebene Beispiel zweier oder mehrerer Linien mit sehr unterschiedlichen Amplituden steht exemplarisch für den häufig vorkommenden Fall von J-gekoppelten NMR-Linien mit oder ohne unterschiedlichen chemischen Verschiebungen. Das bedeutet, dass selbst wenn z.B. nur ein Proton in einem Ziel-Molekül-RASER aktiv ist, trotzdem die Struktur des gesamten Moleküls durch schrittweise Messung aller sehr kleinen J-gekoppelten Satelliten möglich ist. Da in organischen Molekülen das Isotop ¹³C mit 1% natürlicher Häufigkeit vorkommt, besitzt jedes kleinere Molekül (< 20 C-Atome) im Durschnitt einen ¹³C Kern mit einem Spin 1/2 an einer bestimmten Position. Das heißt, das zugehörige J-gekoppelte ¹H-NMR-Spektrum besteht in grober Näherung aus der Sicht dieses einen RASER-aktiven Protons aus einer Hauptlinie (die Mehrheit aller Moleküle ohne ¹³C) und aus einer Superposition von Doublets mit ca. 200-mal kleinerer Amplitude. Die beiden Linien des Doublets liegen im Spektrum bei ν₀ + 0.5 J_{13C-H} und ν₀ - 0.5 J_{13C-H}, wobei jede ¹³C-Position im Spektrum durch seine eigene charakteristische Aufspaltung mit der J-Kopplungskontante J_{13C-H} relativ zu dem RASER-aktiven Proton gekennzeichnet ist. Die Summe aller Doublets sind in erster Ordnung symmetrisch um die Hauptlinie bei v₀ angeordnet. Das Modell mit einer großen Linie 45 mit einer 1000-mal kleineren und verschobenen Linie 46 steht also auch repräsentativ für ¹H-(¹³C,¹⁵N, ²⁹Si etc..) J-gekoppelte NMR-Spektren im Hochfeld, für chemische Verschiebungsdifferenzen (wenn mindestens zwei ¹H Spins mit unterschiedlichen chemischen Verschiebungen RASER-aktiv sind) und schließlich auch für den allgemeineren Fall wo mindestens zwei RASER-aktive ¹H-Gruppen (z.B. ein Ringproton und eine CH₃ Gruppe) miteinander homo-nuklear J-gekoppelt sind. Alles zusammengenommen erlaubt es, die molekulare Struktur des RASER-aktiven organischen Moleküls mit extremer Genauigkeit zu bestimmen.

### Bezugszeichenliste

- 1: System
- 2: Haupt-Vorrichtung
- 3: Referenz-Vorrichtung
- 4a,b: elektrische Schaltung
- 5a,b: elektrischer Schwingkreis
- 6a,b: Schwingkreisspule
- 7a,b: Aufnahmeraum
- 8a,b: aktives Medium
- 9a,b: Kondensator
- 10a,b: Ferritspule
- 11a,b: NIC-Schaltung
- 12a,b: Operationsverstärkerschaltung
- 13a,b: elektrisch regelbarer Widerstand
- 14a,b: erster Widerstand
- 15a,b: zweiter Widerstand
- 16a,b: Operationsverstärker
- 17a,b: Ausgang des Operationsverstärkers
- 18a,b: positiver Eingang des Operationsverstärkers
- 19a,b: negativer Eingang des Operationsverstärkers
- 20a,b: Anschlüsse des Operationsverstärkers
- 21a,b: Verstärker
- 22a,b: Analog-Digital-Wandler
- 23: Hochfrequenzanregungsspule
- 24: Pump-Einrichtung
- 25: Regelkreis
- 26: Amplitudenmessschaltung
- 27: Amplitudenstabilisierungsregler
- 28: Auswerteeinheit
- 29: Addierer
- 30: Elektromagnet
- 31: Magnetspule
- 32: Stromquelle
- 33: Spulenaufnahmeraum
- 34: Auswertevorrichtung
- 35: NIC-Schaltungs- und Kondensator-Steuerungs-Modul
- 36: Arbitrary-HF-Puls-Former/Generator-Modul
- 37: Datenaufnahme-Modul
- 38: Signal-Analyse/FFT-Modul
- 39: Korrektur-Algorithmen-Modul
- 40: HF-Leistungs-Verstärker
- 41: Gate-Anschluss
- 42: erstes Widerstandssymbol
- 43: zweites Widerstandssymbol
- 44: drittes Widerstandssymbol
- 45: Linie der Spezies H₁
- 46: Linie der Spezies H₂
- 47: Rauschen
- B₀: homogenes, statisches Magnetfeld
- G₁: positiver elektrischer Leitwert
- -G₂: erster negativer elektrischer Leitwert
- -G₃: zweiter negativer elektrischer Leitwert
- u₁(t): Ausgangsspannung
- As: Sollamplitude

## Patentansprüche

1. RASER- und/oder NMR-Spektroskopie-Vorrichtung (2, 3) umfassend eine elektrische Schaltung (4a,b), die einen elektrischen Schwingkreis (5a,b) mit einer insbesondere zylinderförmigen oder flachen Schwingkreisspule (6a,b), die einen Aufnahmeraum (7a,b), in dem ein aktives Medium (8a,b) angeordnet oder anordenbar ist, um mit der Schwingkreisspule (6a,b) insbesondere über Faradayinduktion wechselzuwirken, umgibt, und einem insbesondere einstellbaren Kondensator (9a,b) aufweist, **dadurch gekennzeichnet, dass** die elektrische Schaltung (4a,b), insbesondere der elektrische Schwingkreis (5a,b) eine aktive elektronische Einrichtung (11a,b) aufweist, die zur aktiven Entdämpfung des elektrischen Schwingkreises (5a,b) ausgebildet ist.

2. Vorrichtung (2, 3) nach Anspruch 1, **dadurch gekennzeichnet, dass** die aktive elektronische Einrichtung (11a,b) dazu ausgebildet und/oder eingerichtet ist, negative Impedanz zu erzeugen, und/oder dass die aktive elektronische Einrichtung (11a,b) dazu ausgebildet und/oder eingerichtet ist, mit externer elektrischer Energie versorgt zu werden, wobei die aktive elektronische Einrichtung (11a,b), insbesondere wenigstens eine Komponente von dieser bevorzugt wenigstens zwei Anschlüsse (20a,b) zur Verbindung mit einer Spannungs- und/oder Stromquelle aufweist, und/oder dass die aktive elektronische Einrichtung (11a,b) einen Transistor, insbesondere Feldeffekttransistor, einen Verstärker, insbesondere Operationsverstärker (16a,b), eine Diode, insbesondere Tunneldiode, bevorzugt Tunneldiode mit negativer Impedanz, eine NIC-Schaltung, insbesondere INIC- oder UNIC-Schaltung, und/oder eine Schaltung mit einer oder mehreren dieser Komponenten umfasst oder daraus besteht.

3. Vorrichtung (2, 3) nach einem der vorhergehenden Ansprüche, **dadurch gekennzeichnet, dass** die aktive elektronische Einrichtung (11a,b) eine Operationsverstärkerschaltung (12a,b) umfasst, die einen ersten Widerstand (14a,b), einen zweiten Widerstand (15a,b) und einen Operationsverstärker (16a,b), dessen Ausgang (17a,b) bevorzugt unter Zwischenschaltung des ersten Widerstands (14a,b) mit dessen positivem Eingang (18a,b) elektrisch verbunden ist und unter Zwischenschaltung des zweiten Widerstands (15a,b) mit dessen negativem Eingang (19a,b) elektrisch verbunden ist, und der Anschlüsse (20a,b) zum Anlegen einer externen Versorgungsspannung für den Operationsverstärker (16a,b) aufweist, umfasst, und insbesondere die aktive elektronische Einrichtung (11a,b) eine NIC-Schaltung umfasst oder daraus besteht, und die Operationsverstärkerschaltung (12a,b) Teil der NIC-Schaltung der aktiven elektronischen Einrichtung (11a,b) ist, und/oder dass der elektrische Schwingkreis (5a,b) ein Parallelschwingkreis ist, bei dem die Schwingkreisspule (6a,b) parallel zu dem Kondensator (9a,b) geschaltet ist, und die aktive elektronische Einrichtung (11a,b) parallel zu dem Kondensator (9a,b) geschaltet ist.

4. Vorrichtung (2, 3) nach einem der vorhergehenden Ansprüche, **dadurch gekennzeichnet, dass** die aktive elektronische Einrichtung (11a,b) derart ausgebildet und/oder eingerichtet ist, dass die Stärke der von ihr bewirkten Entdämpfung einstellbar, insbesondere regelbar ist, wobei die aktive elektronische Einrichtung (11a,b) vorzugsweise wenigstens einen regelbaren Widerstand, insbesondere ein Potentiometer und/oder einen elektrisch regelbaren Widerstand (13a,b), insbesondere einen Transistor, bevorzugt einen Feldeffekttransistor, umfasst, und insbesondere die aktive elektronische Einrichtung (11a,b) eine NIC-Schaltung umfasst oder daraus besteht, und der regelbare Widerstand (13a,b) Teil der NIC-Schaltung der aktiven elektronischen Einrichtung (11a,b) ist.

5. Vorrichtung (3) nach einem der vorhergehenden Ansprüche, **dadurch gekennzeichnet, dass** die Schwingkreisspule (6b) eine kombinierte Sende-/Empfangsspule ist, und/oder dass ein Magnet (30) vorgesehen ist, der dazu ausgebildet und/oder eingerichtet ist, ein homogenes, statisches Magnetfeld zu erzeugen, und die Schwingkreisspule (6a,b) innerhalb dieses Magnetfelds angeordnet ist, um zumindest einen Teil der Kernspins von Atomen und/oder Molekülen eines in dem Aufnahmeraum (7a,b) der Schwingkreisspule (6a,b) angeordneten aktiven Mediums (8a,b) in Richtung des Magnetfelds des Magneten (30) auszurichten, bevorzugt, wobei der Magnet (30) derart ausgestaltet ist, dass das von ihm erzeugte Magnetfeld eine Homogenität kleiner als 1ppm, bevorzugt kleiner oder gleich 0,01ppm, und/oder eine magnetische Flussdichte von mindestens 100 Gauß und/oder zwischen 1 und 200 Gauß, insbesondere von 100 Gauß aufweist.

6. Vorrichtung (2, 3) nach einem der vorhergehenden Ansprüche, **dadurch gekennzeichnet, dass** in dem von der Schwingkreisspule (6a,b) umgebenen Aufnahmeraum (7a,b) ein aktives Medium (8a,b) angeordnet ist, und das aktive Medium (8a,b) organische Moleküle, RASER-fähige Moleküle, ein organisches Lösungsmittel, insbesondere Methanol, bevorzugt d4-Methanol, Pyridin C₅H₅N, Acetonitril CH₃CN und/oder mit Parawasserstoff hyperpolarisierbare Substanzen umfasst, und/oder das aktive Medium (6), insbesondere aktive PHIP/SABRE-Medium, einen Katalysator, beispielsweise einen [IrCl(COD(IMes))]-Katalysator oder einen anderen Katalysator auf Iridium- oder Rhodium-Basis, umfasst, und/oder dass in dem von der Schwingkreisspule (6a,b) umgebenen Aufnahmeraum (7a,b) ein aktives Medium (8a,b) angeordnet ist, und das aktive Medium (8a,b) ein Feststoff ist, der insbesondere Soft-Polymere umfasst oder aus Soft-Polymeren besteht, oder das aktive Medium (8a,b) eine Flüssigkeit ist, die aktive Zielatome und/oder aktive Zielmoleküle, vorzugsweise Pyridin C₅H₅N oder Acetonitril CH₃CN, umfasst, die insbesondere in einem Lösungsmittel, vorzugsweise Methanol, gelöst sind.

7. Vorrichtung (2) nach einem der vorhergehenden Ansprüche, **dadurch gekennzeichnet, dass** die Vorrichtung (2) dazu ausgebildet und/oder eingerichtet ist, einen Hochfrequenz-Anregungsimpuls in Form eines zeitlich begrenzten hochfrequenten magnetischen Wechselfeldes zu erzeugen, dem ein in dem Aufnahmeraum (7a) der Schwingkreisspule (6a) angeordnetes oder anordenbares aktives Medium (8a) ausgesetzt ist, um von dem hochfrequenten magnetischen Wechselfeld angeregt zu werden, bevorzugt, wobei die elektrische Schaltung (4a) dazu ausgebildet und/oder eingerichtet ist, die Schwingkreisspule (6a) mit einer externen Versorgungsspannung zu speisen, um den Hochfrequenz-Anregungsimpuls mittels der Schwingkreisspule (6a) zu erzeugen, und/oder die elektrische Schaltung (4a) zusätzlich zu der Schwingkreisspule (6a) eine insbesondere als Sattelspule ausgebildete Hochfrequenzanregungsspule (23) aufweist, die dazu ausgebildet und/oder eingerichtet ist, den Hochfrequenz-Anregungsimpuls zu erzeugen, wobei insbesondere die sensitiven Achsen der Schwingkreisspule (6a) und der Hochfrequenzanregungsspule (23) zumindest im Wesentlichen senkrecht aufeinander stehen.

8. Vorrichtung (2, 3) nach einem der vorhergehenden Ansprüche, **dadurch gekennzeichnet, dass** eine Pump-Einrichtung (24) vorgesehen ist, die dazu ausgebildet und/oder eingerichtet ist, Kernspins von Atomen und/oder Molekülen eines in dem Aufnahmeraum (7a,b) angeordneten oder anordenbaren aktiven Mediums (8a,b) insbesondere mittels eines Hyperpolarisationsverfahrens, wie etwa SABRE, DNP, SEOP, SPINOE und/oder PHIP, in einen Zustand negativer oder positiver Kernspinpolarisation zu pumpen.

9. Magnetfeldsensor zur Messung eines Magnetfelds, der eine Vorrichtung (2, 3) nach einem der vorhergehenden Ansprüche umfasst oder daraus besteht, wobei insbesondere in dem Aufnahmeraum (7a,b) ein aktives Medium (8a,b) angeordnet oder anordenbar ist, das bevorzugt nur aktive Moleküle einer Sorte aufweist.

10. Verwendung einer Vorrichtung (2, 3) nach einem der Ansprüche 1 bis 8 für Magnetfeldmessungen und/oder für RASER-Anwendungen und/oder für NMR-Spektroskopie und/oder zur Detektierung von Materialien und/oder zur Messung oder Untersuchung von Molekülstrukturen und/oder zur Vermessung von Kernen für den Metabolismus und/oder beim Reaktions-Monitoring.

11. Verfahren zum Betrieb einer Vorrichtung (2, 3) nach Anspruch 8 insbesondere zur Untersuchung von Atomen und/oder Molekülen eines aktiven Mediums (8a,b), bei dem
a) ein aktives Medium (8a,b) innerhalb des Aufnahmeraums (7a,b) der Schwingkreisspule (6a,b) angeordnet ist oder wird und einem homogenen, statischen Magnetfeld ausgesetzt wird, wodurch zumindest ein Teil der Kernspins von Atomen und/oder Molekülen des aktiven Mediums (8a,b) in Richtung des homogenen, statischen Magnetfelds ausgerichtet wird;
b) Kernspins des aktiven Mediums (8a,b) mittels der Pump-Einrichtung (24) in einen Zustand negativer oder positiver Kernspinpolarisation gepumpt werden,
c) das aktive Medium (8a,b) insbesondere spontan und/oder stimuliert elektromagnetische Strahlung emittiert, die in der Schwingkreisspule (6a,b) eine Spannung induziert, **dadurch gekennzeichnet, dass**
d) der elektrische Schwingkreis (5a,b) durch die aktive elektronische Einrichtung (11a,b) aktiv entdämpft wird, wodurch die RASER-Schwelle, ab der der elektrische Schwingkreis (5a,b) zu schwingen beginnt, herabgesetzt wird.

12. Verfahren zum Betrieb einer Vorrichtung (2) nach Anspruch 7 oder Anspruch 8, sofern auf Anspruch 7 rückbezogen, insbesondere zur Untersuchung von Atomen und/oder Molekülen eines aktiven Mediums (8a), bei dem
a) ein aktives Medium (8a) innerhalb des Aufnahmeraums (7a) der Schwingkreisspule (6a) angeordnet ist oder wird und einem homogenen, statischen Magnetfelds ausgesetzt wird, wobei zumindest ein Teil der Kernspins von Atomen und/oder Molekülen des aktiven Mediums (8a) in Richtung des homogenen, statischen Magnetfelds ausgerichtet wird;
b) ein Hochfrequenz-Anregungsimpuls in Form eines zeitlich begrenzten hochfrequenten magnetischen Wechselfeldes erzeugt wird, und das aktive Medium (8a) dem Hochfrequenz-Anregungsimpuls ausgesetzt wird, sodass das aktive Medium (8a) von diesem angeregt wird;
c) das angeregte aktive Medium (8a) bevorzugt durch Faradayinduktion eine Spannung in der Schwingkreisspule (6a) induziert, **dadurch gekennzeichnet, dass**
d) der elektrische Schwingkreis (5a) durch die aktive elektronische Einrichtung (11a) aktiv entdämpft wird.

13. Verfahren, insbesondere nach Anspruch 11 oder 12 zur Bestimmung der Struktur von Molekülen eines aktiven Mediums (8a), bei dem
a) eine Vorrichtung (2) nach den Ansprüchen 4 und 8 bereitgestellt wird;
b) in dem von der Schwingkreisspule (6a) der Vorrichtung (2) umgebenen Aufnahmeraum (7a) ein aktives Medium (8a), welches Moleküle mit häufigen X-Kernen, wie etwa ¹H-Kernen, mit X-Kernspins und seltenen X-Kernen, wie etwa ¹³C-, ¹⁵N-, ²⁹Si-, ³¹Ph- und/oder ⁵⁷Fe-Kernen, mit X-Kernspins umfasst, angeordnet und insbesondere einem homogenen, statischen Magnetfeld ausgesetzt wird, wodurch zumindest ein Teil der X-Kernspins in Richtung des homogenen, statischen Magnetfelds ausgerichtet wird;
c) X-Kernspins des aktiven Mediums (8a) mittels der Pump-Einrichtung (24) in einen Zustand negativer Kernspinpolarisation gepumpt werden;
d) eine RASER-Aktivität mindestens eines häufigen X-Kerns erzwungen wird, indem mit der aktiven elektronischen Einrichtung (11a) die Güte der Vorrichtung (2), insbesondere des elektrischen Schwingkreises (5a) der Vorrichtung (2), soweit erhöht wird, bis die RASER-Aktivität des häufigen X-Kerns einsetzt, wobei sich neben dem mindestens einen sich in einem RASER-aktiven Zustand befindlichen häufigen X-Kern häufige und/oder seltene X-Kerne in einem RASER-inaktiven Zustand befinden; und
e) wenigstens eine, bevorzugt alle RASER-aktiven Resonanzen/Linien, welche homo- und hetero-nukleare J-Kopplungen zwischen dem mindestens einen RASER-aktiven häufigen X-Kern und den RASER-inaktiven häufigen und/oder RASER-inaktiven seltenen X-Kernen widerspiegeln, durch einen insbesondere schrittweisen Scan mit vorgegebenen Frequenzintervallen in einem vorgegebenen Frequenzbereich nahe der Resonanzfrequenz des häufigen X-Kerns, wobei die Frequenz insbesondere durch Veränderung des Wertes eines einstellbar ausgebildeten Kondensators (9a) variiert wird, gemessen werden, um die Struktur der Moleküle zu bestimmen, insbesondere wobei bei jeder eingestellten Frequenz die Güte der Vorrichtung (2), bevorzugt des elektrischen Schwingkreises (5a) der Vorrichtung (2), mit der aktiven elektronischen Einrichtung (11a) variiert, insbesondere schrittweise erhöht wird.

14. Verfahren, insbesondere nach Anspruch 11 oder 12 zur Bestimmung der Struktur von Molekülen eines aktiven Mediums (8a), bei dem
a) eine Vorrichtung (2) nach den Ansprüchen 4 und 8 bereitgestellt wird;
b) in dem von der Schwingkreisspule (6a) der Vorrichtung (2) umgebenen Aufnahmeraum (7a) ein aktives Medium (8a), welches Moleküle mit X-Kernspins umfasst, angeordnet und insbesondere einem homogenen, statischen Magnetfeld ausgesetzt wird, wodurch zumindest ein Teil der X-Kernspins in Richtung des homogenen, statischen Magnetfelds ausgerichtet wird;
c) X-Kernspins des aktiven Mediums (8a) mittels der Pump-Einrichtung (24) in einen Zustand negativer Kernspinpolarisation gepumpt werden;
d) eine RASER-Aktivität einer verglichen mit zumindest einer weiteren Linie (46) großen Linie (45) erzwungen wird, wobei insbesondere die weitere Linie (46) verglichen mit der großen Linie (45) eine um den Faktor Eintausend kleinere Amplitude aufweist, indem
d1) der elektrische Schwingkreis (5a) insbesondere mittels eines Einstellens des in diesem Fall einstellbar ausgebildeten Kondensators (9a) auf das Maximum der großen Linie (45) eingestimmt wird, und
d2) durch eine aktive Entdämpfung des elektrischen Schwingkreises (5a) mittels der aktiven elektronischen Einrichtung (11a) die Güte der Vorrichtung (2), insbesondere des elektrischen Schwingkreises (5a) der Vorrichtung (2), soweit erhöht wird, bis die RASER-Aktivität der großen Linie (45) einsetzt, oder die Güte auf oder oberhalb der RASER-Schwelle für die große Linie (45) eingestellt wird, so dass die RASER-Aktivität der großen Linie (45) einsetzt;
e) ein X-RASER-Ausgangszeitsignal insbesondere nach einem Einschwingen der RASER-Schwingung in ein stationäres Gleichgewicht an der elektrischen Schaltung (4a), insbesondere an der aktiven elektronischen Einrichtung (11a), abgegriffen und daraus insbesondere mittels einer Fourier-transformation ein X-RASER-Spektrum der Moleküle mit X-Kernspins erhalten wird, das insbesondere zumindest die große Linie (45) umfasst,
f) eine RASER-Aktivität der zumindest einen weiteren Linie (46) erzwungen wird, indem
f1) der elektrische Schwingkreis (5a) insbesondere durch eine Veränderung des Werts des in diesem Fall einstellbar ausgebildeten Kondensators (9a) verstimmt wird, wobei der elektrische Schwingkreis (5a) auf eine Frequenz eingestimmt wird, die höher oder niedriger als die Resonanzfrequenz der großen Linie (45) ist,
f2) mittels der aktiven elektronischen Einrichtung (11a) die Güte der Vorrichtung (2), insbesondere des elektrischen Schwingkreises (5a) der Vorrichtung (2), schrittweise, insbesondere auf einen Wert von mindestens 10⁵, bevorzugt mindestens 10⁶, besonders bevorzugt mindestens 107, erhöht wird, wodurch insbesondere die RASER-Schwelle der zumindest einen weiteren Linie (46) überschritten wird, und
f3) die Resonanzfrequenz in vorgegebenen Frequenzintervallen, beispielsweise für Q = 10⁷ in Intervallen von 0,1 Hz, schrittweise über einen vorgegebenen Frequenzbereich in der Nähe der großen Linie (45) verstimmt wird, insbesondere indem der Wert des in diesem Fall einstellbar ausgebildeten Kondensators (9a) variiert wird, und wenn die Resonanzfrequenz der zumindest einen weiteren Linie (46) erreicht wird, die RASER-Aktivität der zumindest einen weiteren Linie (46) einsetzt; und
g) ein weiteres X-RASER-Ausgangszeitsignal insbesondere nach einem Einschwingen der RASER-Schwingung in ein stationäres Gleichgewicht an der elektrischen Schaltung (4a), insbesondere an der aktiven elektronischen Einrichtung (11a), abgegriffen und daraus insbesondere mittels einer Fouriertransformation ein weiteres X-RASER-Spektrum der Moleküle mit X-Kernspins erhalten wird, das insbesondere die große Linie (45) und die zumindest eine weitere Linie (46) umfasst.

15. System (1) umfassend eine Vorrichtung, Haupt-Vorrichtung (2), nach einem der Ansprüche 1 bis 8 und eine weitere Vorrichtung, Referenz-Vorrichtung (3), nach einem der Ansprüche 1 bis 8, wobei die Referenz-Vorrichtung (3) dazu ausgebildet und/oder eingerichtet ist, ein an der Referenz-Vorrichtung (3) erfasstes Referenz-Messsignal, insbesondere Referenz-Ausgangszeitsignal und/oder ein daraus erhaltenes Referenz-Frequenzspektrum, als Referenz zum Korrigieren von durch Magnetfeldschwankungen und/oder sonstige Umgebungsbedingungen bedingten Störungen in einem an der Haupt-Vorrichtung (2) erfassten Haupt-Messsignal, insbesondere Haupt-Ausgangszeitsignal und/oder einem daraus erhaltenen Haupt-Frequenzspektrum, bereitzustellen.

16. Verfahren zum Betrieb eines Systems (1) nach Anspruch 15, bei dem mittels der Haupt-Vorrichtung (2) ein Haupt-Messsignal, insbesondere Haupt-Ausgangszeitsignal, zur Bestimmung der Struktur von Molekülen mit X-Kernspins eines aktiven Mediums (8a), das diese Moleküle umfasst oder daraus besteht und das in dem Aufnahmeraum (7a) der Haupt-Vorrichtung (2) angeordnet ist oder wird, bereitgestellt wird, aus dem insbesondere ein Haupt-Frequenzspektrum ableitbar ist, und mittels der Referenz-Vorrichtung (3) ein Referenz-Messsignal, insbesondere Referenz-Ausgangszeitsignal, aus dem insbesondere ein Referenz-Frequenzspektrum ableitbar ist, als Referenz zum Korrigieren von durch Magnetfeldschwankungen und/oder sonstigen Umgebungsbedingungen bedingten Störungen in dem Haupt-Messsignal bereitgestellt wird, wobei die Referenz-Vorrichtung (3) mit einem aktiven Medium (8b) mit Atomen und/oder Molekülen mit Y-Kernspins, das in dem Aufnahmeraum (7b) der Referenz-Vorrichtung (3) angeordnet ist oder wird, betrieben wird, und sich die X- und Y-Kernspins unterscheiden, insbesondere ein unterschiedliches gyromagnetisches Verhältnis aufweisen.
